(19) Europäisches Patentamt
European Patent Office
Office européen des brevets

(11) **EP 4 109 049 B1**

(12) **FASCICULE DE BREVET EUROPEEN**

(45) Date de publication et mention de la délivrance du brevet:
**04.10.2023 Bulletin 2023/40**

(21) Numéro de dépôt: **22179700.4**

(22) Date de dépôt: **17.06.2022**

(51) Classification Internationale des Brevets (IPC):
*G01D 5/26* (2006.01)        *G02B 6/293* (2006.01)
*G01L 1/10* (2006.01)        *G01L 1/24* (2006.01)
*G01L 9/00* (2006.01)        *G01N 21/00* (2006.01)
*G01P 15/093* (2006.01)      *G01P 15/097* (2006.01)
*G01V 7/00* (2006.01)        *G01V 8/20* (2006.01)
*G01N 21/77* (2006.01)       *G02B 6/12* (2006.01)

(52) Classification Coopérative des Brevets (CPC):
**G01D 5/268; G01L 1/24; G01N 21/7746;**
**G01V 8/20;** G01P 15/093; G01P 15/097;
G02B 6/293; G02B 6/29335; G02B 2006/12097;
G02B 2006/121; G02B 2006/12107;
G02B 2006/1214

(54) **SYSTEME DE MESURE DE TYPE MEMS OU NEMS MULTICAPTEURS**

MESSSYSTEM VOM TYP MEMS ODER NEMS MIT MEHREREN SENSOREN

MULTISENSOR MEMS OR NEMS TYPE MEASURING SYSTEM

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **25.06.2021 FR 2106811**

(43) Date de publication de la demande:
**28.12.2022 Bulletin 2022/52**

(73) Titulaire: **Commissariat à l'énergie atomique et aux énergies alternatives 75015 Paris (FR)**

(72) Inventeurs:
• **JOURDAN, Guillaume**
  **38054 GRENOBLE Cedex 09 (FR)**
• **HENTZ, Sébastien**
  **38054 GRENOBLE Cedex 09 (FR)**

• **LAMBERTI, Fabrice-Roland**
  **38054 GRENOBLE Cedex 09 (FR)**

(74) Mandataire: **Atout PI Laplace Immeuble "Visium" 22, avenue Aristide Briand 94117 Arcueil Cedex (FR)**

(56) Documents cités:
**US-A1- 2016 246 000**

• DIAO ZHU ET AL: "Integrated On-Chip Nano-Optomechanical Systems", INTERNATIONAL JOURNAL OF HIGH SPEED ELECTRONICS, vol. 26, no. 01n02, mars 2017 (2017-03), pages 1740005-3, XP055891013, GB ISSN: 0129-1564, DOI: 10.1142/S0129156417400055

**Description**

**DOMAINE DE L'INVENTION**

La présente invention concerne le domaine des capteurs à base de MEMS ou NEMS, et plus particulièrement les capteurs utilisant un résonateur optique, par exemple couplé avec un autre élément typiquement mécanique, et la mise en réseaux de ces capteurs.

**ETAT DE LA TECHNIQUE**

Les capteurs à base de MEMS ou NEMS basés sur l'interaction d'une grandeur à mesurer avec un résonateur optique ont connu récemment un grand essor et sont de nature très variée. On entend par capteur MEMS ou NEMS tout capteur bénéficiant des techniques de microfabrication de la microélectronique.

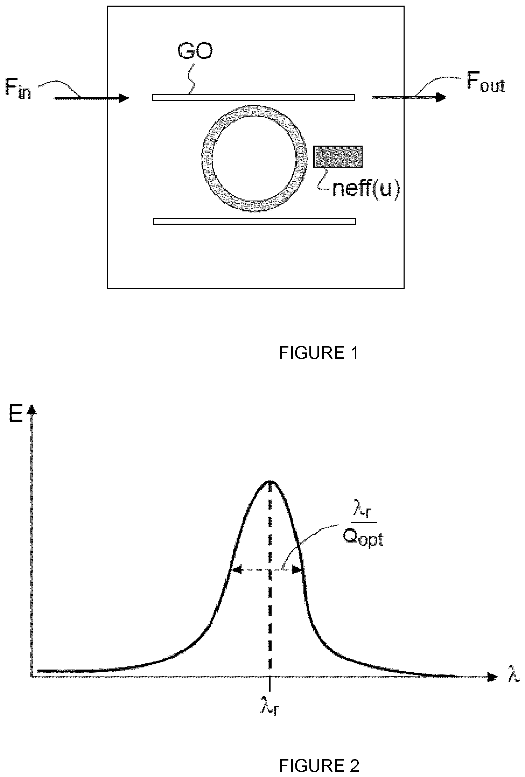

Un capteur de ce type comprend un résonateur optique RO, également dénommé cavité photonique, et un ou plusieurs guides d'ondes GO couplé(s) au résonateur optique, tel qu'illustré en figure 1. Le résonateur optique est caractérisé par au moins une longueur d'onde de résonance λr associée à une bande passante de résonance de largeur λr/Qopt (Qopt facteur de qualité de la cavité optique) tel qu'illustré en figure 2 qui décrit l'énergie E stockée dans le résonateur en fonction de la longueur d'onde.

Les propriétés de propagation des ondes EM dans le résonateur optique sont affectées par un mesurande *u* (grandeur physique à mesurer) ou un paramètre *u* dont la réponse dépend d'un mesurande d'intérêt *z*. Un faisceau lumineux de lecture *Fin* est injecté en entrée du capteur, et l'amplitude et/ou la phase du faisceau lumineux se propageant dans le ou les guide(s) d'onde couplé(s) au résonateur optique RO est perturbée par la grandeur *u*. La fonction de transmission ou de réflexion optique du capteur est ainsi modifiée, directement ou indirectement, par la grandeur physique à mesurer. Le faisceau *Fout* ressort par la sortie du capteur et est détecté par un photodétecteur, et on déduit du faisceau détecté une mesure de la grandeur *u*.

Dans l'exemple de la figure 1 le résonateur optique RO est un anneau dont l'indice effectif de propagation *n*eff(*u*) dépend de *u* pour sa partie réelle et/ou imaginaire. La vitesse de propagation et/ou le taux de dissipation de l'onde lumineuse dans le résonateur optique dépendent ainsi de *u*.

Par exemple pour un capteur destiné à identifier des objets biologiques, l'absorption d'un corps biologique ou autre à la surface du résonateur modifie son indice effectif de propagation et change la position de la longueur d'onde de résonance λr(*u*), *u* étant la quantité absorbée. A partir de la quantité absorbée on détermine la nature du corps (mesurande z).

Ainsi l'identification du corps absorbé est réalisée par la couche de fonctionnalisation qui sélectionne les particules à détecter. Pour donner un exemple de mesurande z dans ce cas de capteur, on peut établir une relation entre le paramètre u qui correspond à une quantité de matériau à détecter et le mesurande z qui peut être la concentration de ce matériau. Les deux sont reliés par un processus d'absorption désorption et peuvent être décrits par une équation d'équilibre biochimique.

De manière plus générale la détection est assurée par la présence d'une couche de fonctionnalisation déposée à la surface ou à proximité (quelques centaines de nm au plus) du résonateur optique. Cette couche :

- peut être identifiée comme l'élément associé au résonateur

- entre dans la chaine de détection du capteur

- peut être ou non spécifique à une espèce chimique ou biologique donnée. Dans ce cas, cette caractéristique de spécificité, croisée éventuellement avec une connaissance partielle de l'échantillon à analyser (On fait l'hypothèse que seuls les objets A, B, C et D constituent le mélange d'entrée et la couche absorbe essentiellement B), permet de réaliser l'identification de l'objet,

- peut être constituée par un matériau biologique ou chimique ajouté au résonateur ou être intégré directement sur / dans le résonateur : la surface du résonateur ou l'intérieur du résonateur (matériau poreux).

Selon un autre exemple, le capteur comprend un résonateur optique RO couplé avec un élément mécanique dont on mesure le déplacement. Ce type de capteur est dénommé capteur optomécanique.

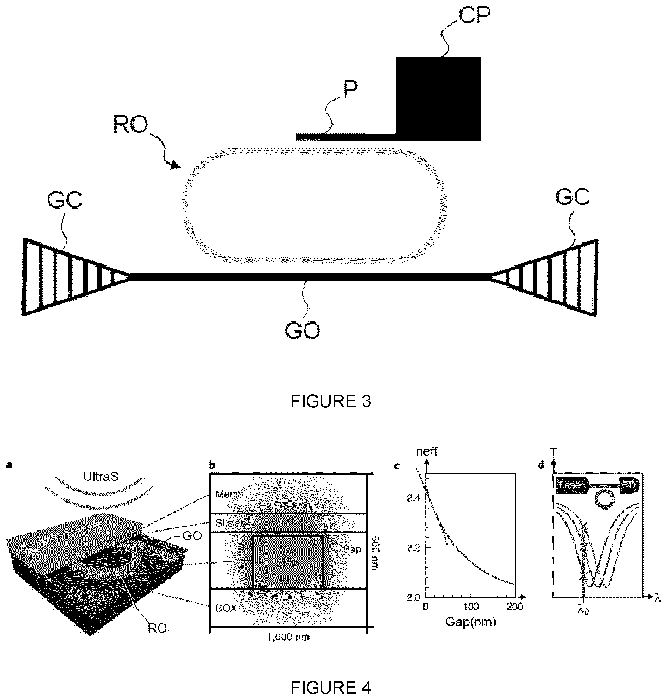

La figure 3 illustre un tel capteur dans lequel l'élément mécanique est une poutre cantilever P fixée à une extrémité à un plot CP. Le faisceau de lecture est injecté dans le guide GO et récupéré en sortie de guide par un réseau de couplage GC (« grating coupler »). Le déplacement x de la poutre (paramètre u) dans le champ évanescent du résonateur optique perturbe l'indice effectif (variation du « gap » entre la poutre et l'anneau). A partir du déplacement x on mesure par exemple l'accélération d'un corps (mesurande z).

Selon un autre exemple le résonateur optique est couplé avec un élément mécanique résonnant à une fréquence *frm.* Un exemple d'OMUS (« Optomechanical Ultrasound Sensor ») est décrit dans la publication Westerveld et al, « Sensitive, small, broadband and scalable optomechanical ultrasound sensor in silicon photonics », Nature Photonics Letters 2021 et illustré figure 4. L'élément mécanique résonant est une membrane *Memb* sur une fine couche de silicium Si slab, dont la vibration (résonance) est induite par une onde ultrasonore *UltraS* à mesurer lorsque la fréquence de l'onde est proche de la fréquence de résonance mécanique *frm* de la membrane. La membrane agit comme un filtre passe bande qui sélectionne les composantes spectrales de l'onde incidente au voisinage de sa fréquence de résonance. La membrane est disposée par-dessus un anneau RO également en silicium (couplé à un guide optique GO et disposé sur un substrat BOX) à une distance dénommée *Gap* (voir a et b). La teinte foncée montre l'intensité du champ électromagnétique au voisinage du résonateur optique, l'intensité est élevée dans la région entre la membrane et le résonateur. L'indice effectif du résonateur *neff* est modifié par la valeur du *Gap* (voir c). Lorsque la membrane vibre le déplacement x de la membrane fait varier le gap et donc l'indice effectif. L'onde *UltraS* modifie ainsi la valeur de la longueur d'onde de résonance du résonateur optique. Ce décalage en longueur d'onde de résonance est lu par un laser émettant un faisceau lumineux à une longueur d'onde $\lambda 0$ située sur un flanc de la résonance du résonateur optique (c'est-à-dire compris dans la bande passante de résonance de RO), qui est injecté dans le guide d'onde. Le faisceau lumineux est détecté en sortie de guide par un photodétecteur PD. Le décalage se traduit par une variation de la transmission T du capteur (rapport des intensités) à la longueur d'onde $\lambda 0$. Les trois courbes de d correspondent à différentes amplitudes de déflexion de la membrane. Chaque courbe correspond à une position de la membrane. Lors de la vibration de cette dernière, on passe d'une courbe à l'autre de manière périodique.

Selon encore un autre exemple l'élément mécanique résonnant est confondu avec le résonateur optique, qui présente alors une résonance optique et une résonance mécanique.

Tous les capteurs précités sont dits capteurs actifs, car ces capteurs utilisent l'énergie apportée par le mesurande pour réaliser la transduction, aucune excitation externe n'est appliquée au capteur: la force de l'onde ultrasonore active la membrane, la force inertielle met en mouvement la masse mobile, etc.

Pour une autre classe de capteurs, dit passifs, ces capteurs subissent une modification d'un de leurs paramètres physiques. Par exemple, la fréquence de résonance du système mécanique ou son facteur de qualité, la résistance électrique d'une jauge de déformation, etc. Dans ce cas, il est nécessaire d'apporter une excitation extérieure (une polarisation) pour réaliser la lecture de ce paramètre. Ce moyen d'excitation est nécessaire pour certaines catégories de capteur.

Par exemple l'élément mécanique résonnant est excité à une fréquence d'excitation externe *fex* comprise dans la bande de résonance mécanique BPm autour d'une fréquence de résonance mécanique *frm.*

Le document EP3244169, ainsi que la publication Diao et al «Integrated on-chip nano-optmechanical systems» International Journal of High Speed Electronics and Systems ; vol 26, n° 1 & 2 (2017), décrivent l'exemple d'une poutre mise en résonance mécanique en étant actionnée à une fréquence d'excitation proche de sa résonance. Comme sur la figure 3, la poutre est localisée au voisinage du résonateur optique. La présence d'une masse additionnelle sur la poutre modifie la fréquence de résonance mécanique de celle-ci. Le signal de mesure produit par l'actionnement permet d'extraire les variations de fréquence de résonance $\delta f$ grâce au déphasage induit par la réponse mécanique par rapport au signal d'actionnement. On réalise ainsi un capteur de masse gravimétrique.

Le document US2016/246000 A1 décrit un autre exemple connu de capteur de type MEMS comprenant un ensemble résonnant.

Dans un autre exemple de capteur passif, le résonateur optique et le résonateur mécanique sont confondus. Il s'agit par exemple d'un disque vibrant présentant à la fois une résonance optique et mécanique : par exemple un capteur fonctionnant en milieu liquide pour détecter des objets biologiques (virus, protéines, etc) qui se déposent sur ce disque. On mesure la masse additionnelle absorbée sur ces disques (on utilise une couche de fonctionnalisation ou non), qui permet de remonter à la concentration de l'espèce biologique. La masse alourdit le disque, ce qui modifie sa fréquence de résonance mécanique. Il s'agit selon un autre exemple d'un capteur de force atomique sous la forme d'un anneau muni d'une pointe mise en résonance, tel que décrit dans la publication de Allain et al « Optomechanical resonating probe for very high frequency sensing of atomic forces » Nanoscale, 2020, 12, 2939.

Afin de multiplier les mesures et/ou d'augmenter la précision ou les fonctionnalités du capteur, il est intéressant de mettre ces capteurs actifs ou passifs en réseau.

La mise en réseau de capteurs de masse gravimétrique présente un grand intérêt :

- augmentation de la surface de capture de la masse (plus grande sensibilité de mesure), ou du nombre d'évènements détectés,

- fonctionnalisations différentes pour sélectionner les espèces,

- information de position des particules : par exemple dans une colonne de chromatographie, la position est une information importante pour localiser des espèces biologiques / chimiques et mesurer leurs quantités respectives,

- redondance de l'information pour moyenner le signal et augmenter la résolution,

- redondance des capteurs pour augmenter la robustesse du système. Au cours de l'utilisation, des composants peuvent se détériorer et ne plus fonctionner correctement. Ce peut être des problèmes d'encrassement malgré le rinçage du système, de la casse mécanique, etc. Le système est alors toujours apte à fonctionner, ce qui permet d'augmenter sa durée de vie.

La mise en réseau de capteurs à ultrasons permet à chaque capteur de jouer le rôle de filtre en n'étant sensible qu'à sa gamme de fréquence. En outre on peut également extraire une information sur la direction de l'onde ultrasonore à travers le déphasage du signal entre les capteurs.

Se pose alors le problème de la lecture de l'information associée à chaque capteur.

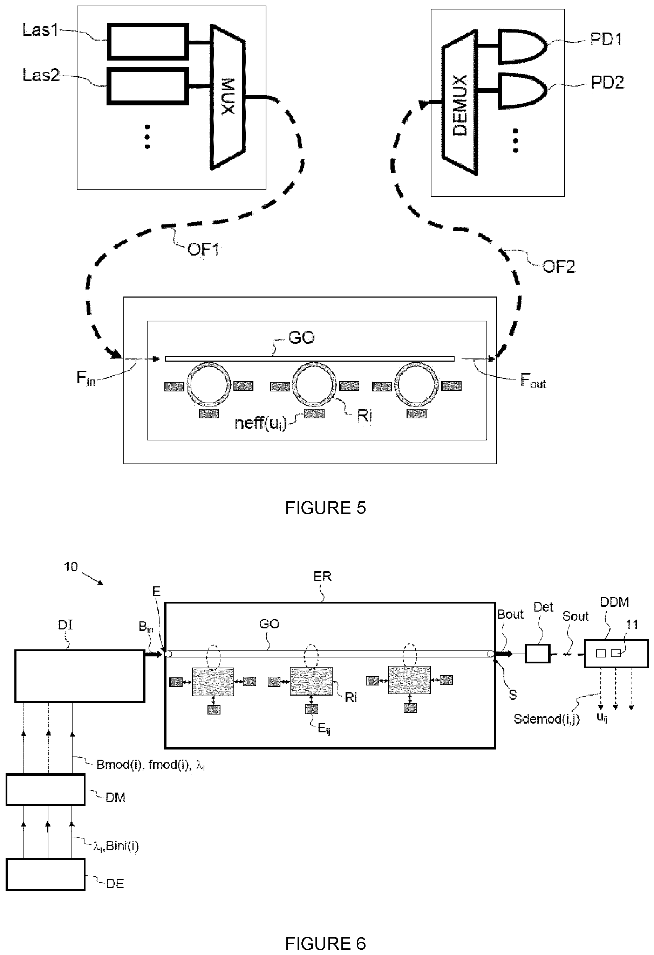

Dans la publication Westerveld précitée la lecture d'un ensemble de capteurs en réseau s'effectue par multiplexage/démultiplexage en longueur d'onde, en associant une longueur d'onde à chaque capteur. Le principe est illustré figure 5. L'ensemble de capteurs est illustré par des résonateurs Ri dont l'indice effectif *neff(ui)* est modifié par un mesurande u (l'élément mécanique éventuellement présent n'est pas représenté), couplés à un même guide d'onde. Cette méthode mux/demux s'inspire d'une procédure standard de mélange/séparation de signaux pour les télécoms (WDM pour Wavelength Multiplexing Division en anglais ou multiplexage en longueur d'onde). Un multiplexeur *MUX* mélange les faisceaux émis par les lasers Las1, Las2 .., respectivement aux longueurs d'onde $\lambda 1$, $\lambda 2$ .... Les faisceaux mélangés sont transportés jusqu'au réseau de capteurs par une fibre optique OF1, et l'onde $F_{in}$ issue de la superposition des différents faisceaux est injectée dans le guide d'onde GO. En sortie du capteur l'onde $F_{out}$ est dirigée par une fibre optique OF2 vers un démultiplexeur *DEMUX* relié à des photodétecteurs PD1, PD2 ... recueillant chacun un faisceau à une longueur d'onde déterminée.

Cette méthode présente les inconvénients suivants :

- besoin de composants optiques de multiplexage / démultiplexage,

- la reconfiguration des longueurs d'onde du mux/demux n'est pas toujours possible: elle n'est pas adaptable facilement au système de capteurs à traiter (variabilité des longueurs d'onde de résonance à la fabrication),

- les mux/demux offrent souvent un pas de longueur d'onde régulier, qui n'est pas toujours adapté pour des résonateurs optiques dont la variabilité des longueurs d'onde peut être du même ordre de grandeur (quelques nm) que le pas du mux/demux. Il peut être difficile d'optimiser le réseau du mux/demux avec les positions des résonateurs optiques.

Toujours afin de multiplier les mesures il est possible de positionner plusieurs éléments par résonateur optique. Le document EP2866000 décrit un capteur de masse gravimétrique constitué d'un ensemble de quatre plateaux vibrants disposés par-dessus un anneau optique, formant quatre capteurs permettant de mesurer plus de masses de particules.

Par extension il est possible de mettre plusieurs résonateurs optiques en réseaux, chaque résonateur optique étant associé à plusieurs éléments mécaniques. Chaque paire résonateur optique/élément associé forme alors un capteur. Mais se pose également le problème d'accès aux informations associées à chaque capteur.

Un but de la présente invention est de remédier aux inconvénients précités en proposant un système de mesure comprenant plusieurs résonateurs optiques couplés à au moins un guide d'onde, et le cas échéant plusieurs éléments associés à un résonateur optique, le système de mesure permettant la récupération simultanée de l'information individuelle issue de chaque capteur élémentaire résonateur optique/élément, et donc d'accéder à toutes les valeurs mesurées par tous les capteurs.

**DESCRIPTION DE L'INVENTION**

La présente invention a pour objet un système de mesure de type MEMs et/ou NEMs comprenant :

- un ensemble résonnant comprenant :

  --une entrée et une sortie,

  --une pluralité de N résonateurs optiques Ri indicés i présentant chacun une longueur d'onde de résonance $\lambda r,i$,

--au moins un guide d'onde auquel sont couplés les résonateurs optiques,

--au moins un élément couplé à chaque résonateur Ri et configuré pour modifier une transmission ou une réflexion optique au voisinage de la résonance dudit résonateur optique, ladite modification étant fonction d'une grandeur physique à mesurer,

- un dispositif d'émission configuré pour émettre une pluralité de N faisceaux lumineux présentant chacun une longueur d'onde d'émission $\lambda i$ comprise dans la bande de résonance du résonateur optique associé,

- un dispositif de modulation configuré pour moduler chacun des faisceaux lumineux à une fréquence de modulation fmod(i),

- un dispositif d'injection configuré pour superposer les N faisceaux lumineux pour former un faisceau d'entrée (Bin) et pour injecter le faisceau en entrée de l'ensemble résonant,

- au moins un détecteur configuré pour détecter un faisceau lumineux issu du faisceau en sortie de l'ensemble résonnant (Bout) et générer un signal de sortie (Sout),

- un dispositif de démodulation comprenant au moins N modules de démodulation de type détection synchrone, dénommé LIA, pour démoduler le signal de sortie, de manière à extraire des signaux caractéristiques associés à chaque élément, des valeurs mesurées de ladite grandeur physique étant déterminées à partir desdits signaux caractéristiques.

Selon un mode de réalisation le dispositif de modulation est disposé en amont du dispositif d'injection, la superposition des N faisceaux lumineux modulés (Bmod(i)) formant le faisceau d'entrée.

Selon un mode de réalisation le dispositif d'émission comprend N lasers et le dispositif de modulation comprend N modulateurs disposés respectivement sur les trajets optiques des N faisceaux lumineux émis par les N lasers, chaque modulateur étant configuré pour moduler le faisceau lumineux associé à la fréquence fmod(i).

Selon un mode de réalisation les modulateurs sont des modulateurs électrooptiques.

Selon un mode de réalisation le dispositif d'émission et le dispositif de modulation forment un même dispositif comprenant N lasers modulés en intensité.

Selon un mode de réalisation un module de démodulation LIA comprend un oscillateur de référence à une fréquence de démodulation et une première chaine de démodulation comprenant un mélangeur et un filtre passe bas. Préférentiellement un module de démodulation LIA comprend une deuxième chaine de démodulation en quadrature avec la première chaine.

Selon un mode de réalisation le résonateur optique est choisi parmi : un disque, un guide rebouclé sur lui-même, un cristal photonique.

Selon une première variante un seul élément est associé à chaque résonateur optique et le dispositif de démodulation comprend N modules de démodulation LIA configurés pour opérer N démodulations auxdites fréquences de modulation fmod(i).

Selon un mode de réalisation au moins un élément Eij est résonnant et présente une fréquence caractéristique fc(i,j) comprise dans une bande de résonance de l'élément résonant Eij, j étant l'indice de l'élément associé au résonateur Ri.

Selon un mode de réalisation un seul élément est associé à chaque résonateur optique et le dispositif de démodulation comprend N modules de démodulations LIA configurés pour opérer respectivement N démodulations aux fréquences fmod(i) +/- fc(i) lorsque fc(i) existe et aux fréquences fmod(i) sinon.

Selon un mode de réalisation un seul élément est associé à chaque résonateur optique et le dispositif de démodulation comprend un premier étage de N modules de démodulations LIA (11) configurés pour opérer respectivement N démodulations aux fréquences fmod(i), et un deuxième étage comprenant soit des filtres spectraux configurés pour opérer, pour chaque canal i pour lequel la fréquence fc(i) existe, un filtrage spectral autour de fc(i) pour extraire le signal caractéristique associé, soit des démodulateurs LIA aux fréquences fc(i).

Selon un mode de réalisation l'élément est confondu avec le résonateur optique.

Selon une deuxième variante au moins un résonateur optique comprend une pluralité d'éléments associés Eij comprenant des éléments résonants, un résonateur Ri comprenant Mi éléments associés, l'ensemble résonnant comprenant un total de M éléments.

Selon un mode de réalisation le dispositif de démodulation comprend M modules de démodulation LIA configurés pour opérer respectivement M démodulation aux fréquences fmod(i) +/- fc(i,j) lorsque fc(i,j) existe et aux fréquences fmod(i) sinon.

Selon un mode de réalisation le dispositif de démodulation comprend un premier étage comprenant N modules de démodulation LIA configurés pour opérer respectivement N démodulation aux fréquences fmod(i) et comprend, pour chaque canal i pour lequel au moins une fréquence caractéristique existe, un deuxième étage comprenant des modules de démodulation LIA (11) aux fréquences caractéristiques fc(i,j).

Selon un mode de réalisation le dispositif de démodulation comprend un premier étage comprenant N modules de démodulation LIA configurés pour opérer respectivement N démodulation aux fréquences fmod(i) et comprend, pour chaque canal i pour lequel au moins une fréquence caractéristique existe, un deuxième étage comprenant des filtres spectraux (BPF) configurés pour opérer un filtrage spectrale autour de la fréquence caractéristique fc(i,j).

Selon un mode de réalisation la fréquence caractéristique est une fréquence de vibration naturelle induite par la grandeur physique à mesurer.

Selon un mode de réalisation la fréquence caractéristique est une fréquence d'excitation externe dudit élément.

Selon un autre aspect l'invention concerne un procédé de mesure d'une grandeur physique (u) comprenant les étapes consistant à :

A émettre une pluralité de N faisceaux lumineux présentant chacun une longueur d'onde d'émission λi,

B moduler chacun des faisceaux lumineux à une fréquence de modulation fmod(i),

C superposer les N faisceaux lumineux pour former un faisceau d'entrée et pour injecter le faisceau en entrée d'un l'ensemble résonant,
l'ensemble résonnant comprenant :

- une entrée et une sortie,

- une pluralité de N résonateurs optiques Ri indicés i présentant chacun une longueur d'onde de résonance λr,i, la longueur d'onde λi étant comprise dans la bande de résonance du résonateur optique Ri associé,

- au moins un guide d'onde (GO) auquel sont couplés les résonateurs optiques,

- au moins un élément positionné au voisinage de chaque résonateur Ri

D modifier une transmission ou une réflexion optique au voisinage de la résonnance de chaque résonateur optique, ladite modification étant fonction de la grandeur physique à mesurer,

E détecter un faisceau lumineux en sortie de l'ensemble résonnant et générer un signal de sortie,

F démoduler de manière synchrone le signal de sortie, à partir d'au moins N modules de démodulation de type détection synchrone, de manière à extraire des signaux caractéristiques associés à chaque élément, des valeurs mesurées de ladite grandeur physique étant déterminées à partir desdits signaux caractéristiques.

La description suivante présente plusieurs exemples de réalisation du dispositif de l'invention : ces exemples sont non limitatifs de la portée de l'invention. Ces exemples de réalisation présentent à la fois les caractéristiques essentielles de l'invention ainsi que des caractéristiques additionnelles liées aux modes de réalisation considérés.

L'invention sera mieux comprise et d'autres caractéristiques, buts et avantages de celle-ci apparaîtront au cours de la description détaillée qui va suivre et en regard des dessins annexés donnés à titre d'exemples non limitatifs et sur lesquels :

La figure 1 déjà citée illustre un exemple de capteur basé sur la modification de l'indice effectif d'un résonateur optique.

La figure 2 déjà citée illustre les paramètres de la résonance d'un résonateur optique.

La figure 3 déjà citée illustre un exemple de capteur comprenant un élément mécanique couplé au résonateur optique.

La figure 4 déjà citée illustre un exemple de capteur comprenant une membrane vibrante couplée à un résonateur optique.

La figure 5 déjà citée illustre la méthode de multiplexage/démultiplexage en longueur d'onde connue de l'homme de l'art.

La figure 6 illustre un système de mesure selon l'invention.

La figure 7 illustre un agencement en parallèle des résonateurs optiques.

La figure 8 illustre un mode de réalisation dans lequel le dispositif d'émission et le dispositif de modulation forment un même dispositif comprenant N lasers modulés en fréquence.

La figure 9 illustre un mode de réalisation dans lequel le dispositif de modulation est disposé en aval de la sortie de l'ensemble ER, avant le détecteur.

La figure 10 illustre un mode de réalisation dans lequel la modulation d'intensité est réalisée par un interféromètre Mach Zender.

La figure 11 illustre un mode de réalisation dans lequel un module de démodulation cohérente comprend deux voies en quadrature.

La figure 12 illustre une première variante d'ensemble résonant dans laquelle un seul élément Ei est associé à chaque résonateur optique d'ensemble résonant, et une première architecture de démodulation à un étage.

La figure 13 illustre l'exemple d'un ensemble résonant comprenant 3 disques constituant à la fois le résonateur optique et le résonateur mécanique.

La figure 14 illustre la première variante d'ensemble résonant dans laquelle certains éléments sont résonants avec des fréquences caractéristiques, et une deuxième architecture de démodulation, dite à deux étages.

La figure 15 illustre une deuxième variante d'ensemble résonant dans laquelle au moins un résonateur optique comprend une pluralité d'éléments associés Eij résonants, et illustre une architecture de démodulation à un étage dans laquelle le dispositif de démodulation comprend M modules de démodulation LIA configurés pour opérer respectivement M démodulation aux fréquences fmod(i) +/- fc(i,j) lorsque fc(i,j) existe, et aux fréquences fmod(i) sinon.

La figure 16 illustre la deuxième variante d'ensemble résonant et une architecture à un étage, pour un cas mixte avec N=3 : R1 comprend 3 éléments résonants E11, E12, et E13 ; R2 comprend un seul élément résonant E21 ; R3 comprend un élément non résonant E31.

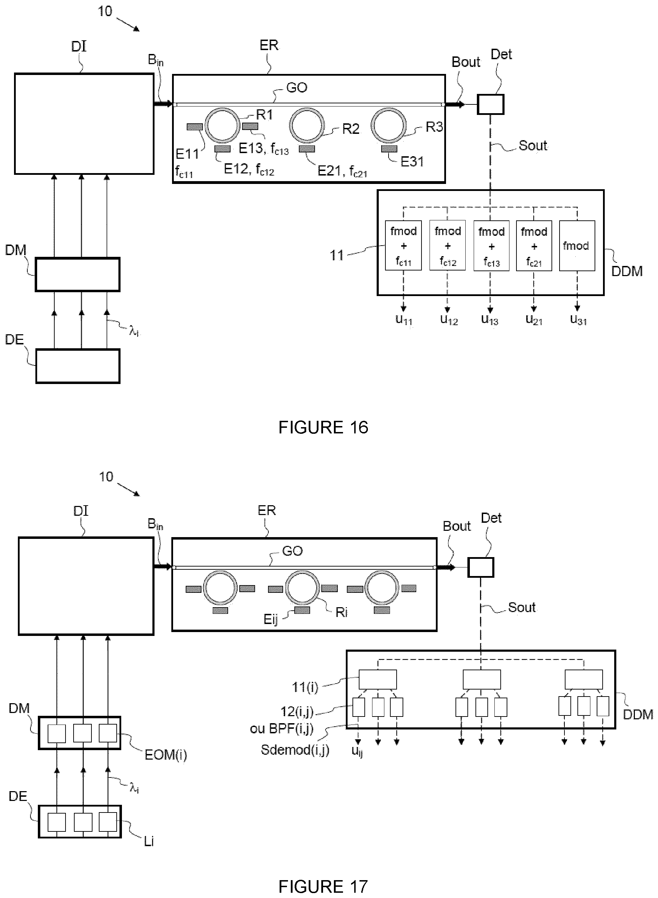

La figure 17 illustre la deuxième variante d'ensemble résonant et une architecture à deux étages. Le dispositif de démodulation DDM comprend un premier étage comprenant N modules de démodulation LIA configurés pour opérer respectivement N démodulation aux fréquences fmod(i) et comprend, pour chaque canal i pour lequel au moins une fréquence caractéristique existe, un deuxième étage de modules de démodulation LIA aux fréquences caractéristiques fc(i,j) (lorsqu'elles existent) ou de filtres spectraux BPF configurés pour opérer un filtrage spectral autour de la fréquence caractéristique fc(i,j). Un filtre passe bas est utilisé pour les capteurs sans fréquence caractéristique.

La figure 18 illustre l'ensemble résonnant mixte de la figure 16 et une architecture de démodulation à deux étages. On a 3 démodulateurs LIA pour le premier étage, et pour le deuxième étage : canal 1 : soit 3 démodulateurs LIA à fc11, fc12, fc13, soit trois filtres spectraux centrés sur ces fréquences ; canal 2 : un filtre spectral à fc21 ; canal 3 : aucun deuxième étage (un filtre passe bas est optionnel).

La figure 19 illustre un mode de réalisation du système de mesure selon l'invention, dans lequel le système de mesure est combiné avec un dispositif de multiplexage / démultiplexage en longueur d'onde.

## DESCRIPTION DETAILLEE DE L'INVENTION

Le système de mesure 10, de type MEMs et/ou NEMs, est illustré en figure 6.
Il comprend tout d'abord un ensemble résonnant ER comprenant une entrée E et une sortie S, une pluralité de N résonateurs optiques Ri indicés i présentant chacun une longueur d'onde de résonance $\lambda r,i$, et au moins un guide d'onde GO auquel sont couplés les résonateurs optiques.
Le système 10 comprend également au moins un élément Eij couplé à chaque résonateur Ri et configuré pour modifier une transmission ou une réflexion optique au voisinage de la résonance du résonateur optique Ri associé, la modification étant fonction d'une grandeur physique à mesurer. Les résonateurs optiques sont indicés i variant de 1 à N, et les éléments associés à un résonateur i sont indicés j : Eij. Le nombre d'éléments associés à chaque résonateur peut être identique pour tous les résonateurs (facilité de fabrication et de lecture) mais ce n'est pas obligatoire. Un ensemble Eij/Ri forme un capteur élémentaire Cij et l'ensemble ER forme un réseau de capteurs. Au sein d'un ensemble ER plusieurs types de capteurs peuvent être mélangés.

Des exemples de résonateurs Ri sont : un guide rebouclé sur lui-même (tel un anneau), un disque, un cristal photonique (structuration périodique d'un élément diélectrique qui permet un confinement de la lumière).

Comme expliqué plus haut la transmission/réflexion optique d'un résonateur Ri est modifiée par une grandeur physique u, qui peut être soit directement la grandeur physique finale que l'on souhaite mesurer, soit un paramètre duquel dépend la grandeur finale à mesurer z. Le système de mesure selon l'invention a pour objectif la mesure de la grandeur physique u. On dénomme uij la valeur mesurée de ce paramètre u par l'élément Eij associé au résonateur Ri (capteur Cij), et il est entendu que lorsque u est un paramètre intermédiaire, on détermine ensuite la mesure zij à partir de uij.

Selon un mode de réalisation l'entrée et la sortie sont localisées à deux endroits différents, par exemple aux deux extrémités d'un même guide d'onde. Selon un autre mode de réalisation l'entrée E et la sortie S sont confondues, par exemple dans le cas d'une modification de la réflexion.

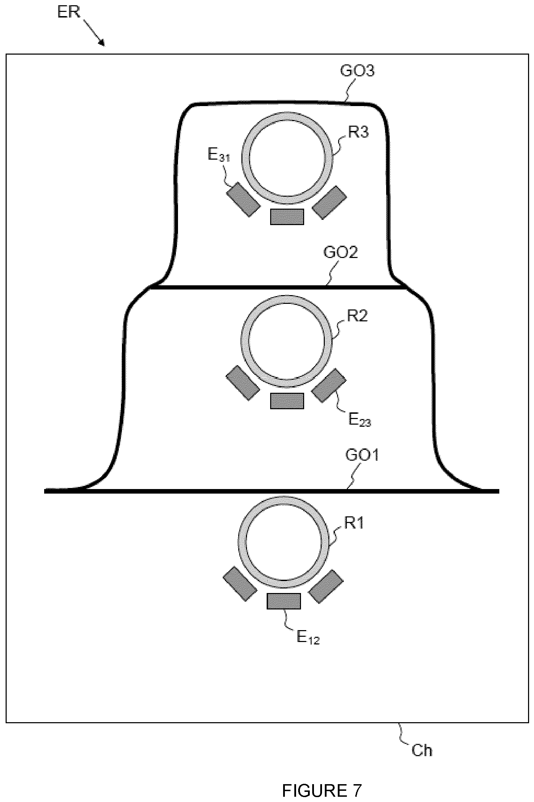

Selon un mode de réalisation les résonateurs sont agencés en série selon un guide d'onde, mais d'autres modes de réalisation avec des agencements plus complexes sont possibles, mêlant résonateurs en série et/ou en parallèle. Un exemple d'agencement en parallèle est illustré en figure 7 (GO1, GO2 et GO3 en parallèle).

Selon un mode de réalisation également illustré en figure 7 l'ensemble résonant ER de capteurs en réseau est réalisé sur une puce Ch, par exemple en Silicium.

Le système de mesure 10 selon l'invention comprend également un dispositif d'émission DE configuré pour émettre une pluralité de N faisceaux lumineux présentant chacun une longueur d'onde d'émission $\lambda i$ comprise dans la bande de résonance du résonateur optique associé Ri. On appelle bande spectrale de résonance du résonateur Ri la bande spectrale BPopt autour de la fréquence de résonance, caractérisée par le paramètre Qopt tel qu'illustré en figure 2 : BPopt = $\lambda r$/Qopt.

Les différentes longueurs d'onde $\lambda i$ doivent être choisies de manière à avoir des bandes spectrales de résonance disjointes, pour éviter qu'une longueur d'onde émise par un laser puisse adresser deux RO différents.

Le système comprend également un dispositif de modulation DM configuré pour moduler chacun des faisceaux lumineux à une fréquence de modulation fmod(i) et un dispositif d'injection DI configuré pour superposer les N faisceaux lumineux pour former un faisceau d'entrée *Bin* et pour injecter le faisceau en entrée de l'ensemble résonant ER. Le faisceau d'entrée *Bin* est le faisceau sonde, ou de lecture, qui va lire les mesures réalisées par les capteurs Cij, via la modification de la réponse optique des résonateurs Ri. Le faisceau en sortie de l'ensemble ER est dénommé Bout.

La superposition des faisceaux s'effectue par exemple à l'aide de lames ou de cubes dénommés « beam splitters » en anglais, ou avec un multiplexeur dénommé Arrayed Waveguide Grating (AWG). L'injection dans le guide d'onde s'opère par exemple avec une fibre optique couplée à un réseau de diffraction (« grating coupler » en anglais) ou par un couplage par la tranche, avec une fibre optique positionnée dans le même plan que le substrat.

Le système comprend également au moins un détecteur *Det*, par exemple une photodiode, configuré pour détecter un faisceau lumineux issu du faisceau en sortie *Bout*, et générer un signal électrique de sortie *Sout.*

Les dispositifs DM et DI peuvent être intégrés sur une même puce, différente de la puce de l'ensemble ER ou identique. Le détecteur *Det* peut être intégré sur la puce Ch de l'ensemble ER le cas échéant.

Sur la figure 6 et les suivantes, les faisceaux optiques sont symbolisés par un trait plein et les signaux électriques par un trait en pointillé, pour rendre les schémas plus lisibles.

Préférentiellement la fréquence de modulation fmod(i) de chaque faisceau est générée à partir d'un oscillateur source Oscs(i).

Selon une variante préférée le dispositif de modulation est disposé en amont de l'entrée E de ER. On dénomme Bmod(i) les faisceaux modulés en sortie du dispositif DM, et la superposition des N faisceaux lumineux modulés Bmod(i) forme le faisceau d'entrée *Bin.*

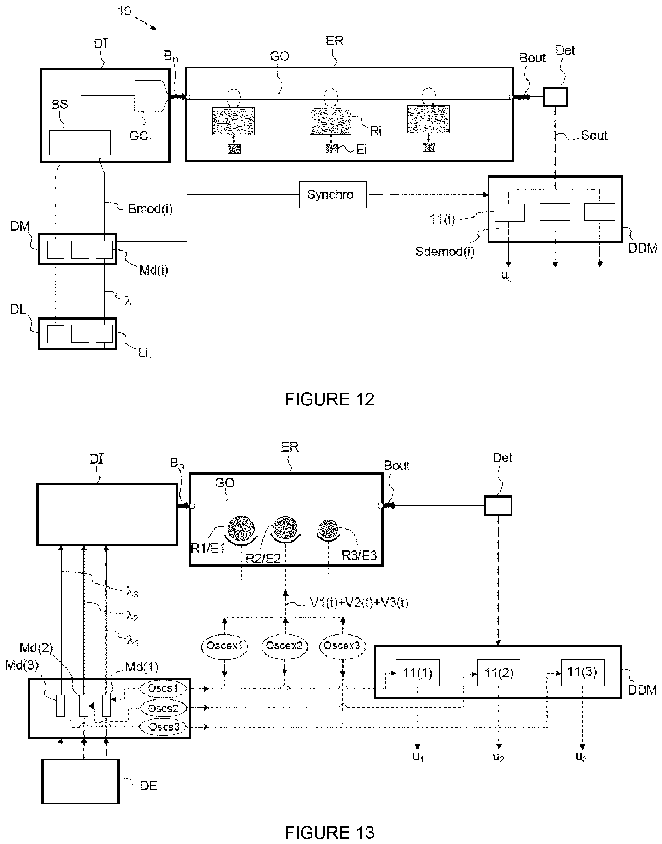

Selon un premier mode de réalisation de cette première variante illustrée en figure 6 le dispositif DM est disposé en amont du dispositif DI. Selon une première option illustrée en figure 12 le dispositif d'émission DE comprend N lasers Li émettant des faisceaux Bini(i) et le dispositif de modulation DM comprend N modulateurs Md(i) disposés respectivement sur les trajets optiques des N faisceaux lumineux émis par les N lasers, et configurés pour moduler chaque faisceaux lumineux à la fréquence fmod(i). Préférentiellement les modulateurs sont des modulateurs électrooptiques EOM(i).

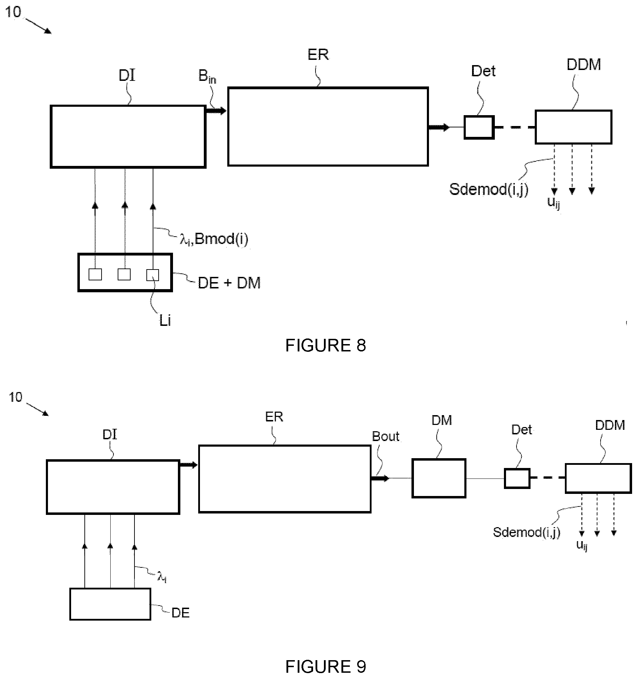

Selon une deuxième option illustrée en figure 8 le dispositif d'émission DE et le dispositif de modulation DM forment un même dispositif comprenant N lasers Li modulés en fréquence (modulation en amplitude à une fréquence donnée), par exemple des diodes lasers alimentées par un courant modulé. Le dispositif DM est alors compact.

Selon un deuxième mode de réalisation de la première variante, non représenté, le dispositif DM est disposé après la superposition des faisceaux, dans le dispositif d'injection.

Selon une deuxième variante illustrée en figure 9 le dispositif de modulation est disposé en aval de la sortie S de l'ensemble ER, avant le détecteur *Det.*

Selon un mode de réalisation préféré le dispositif de modulation réalise une modulation d'intensité. Cette modulation d'intensité s'effectue par exemple de manière directe (lasers modulés), via une absorption (modulateurs électro optiques), via une interférence de type Mach Zender (MZ) ou une interférence de type résonateur. Ce dernier type de modulation est compatible pour un positionnement de DM en aval de la superposition avant l'entrée E de ER, ou entre la sortie de ER et le détecteur.

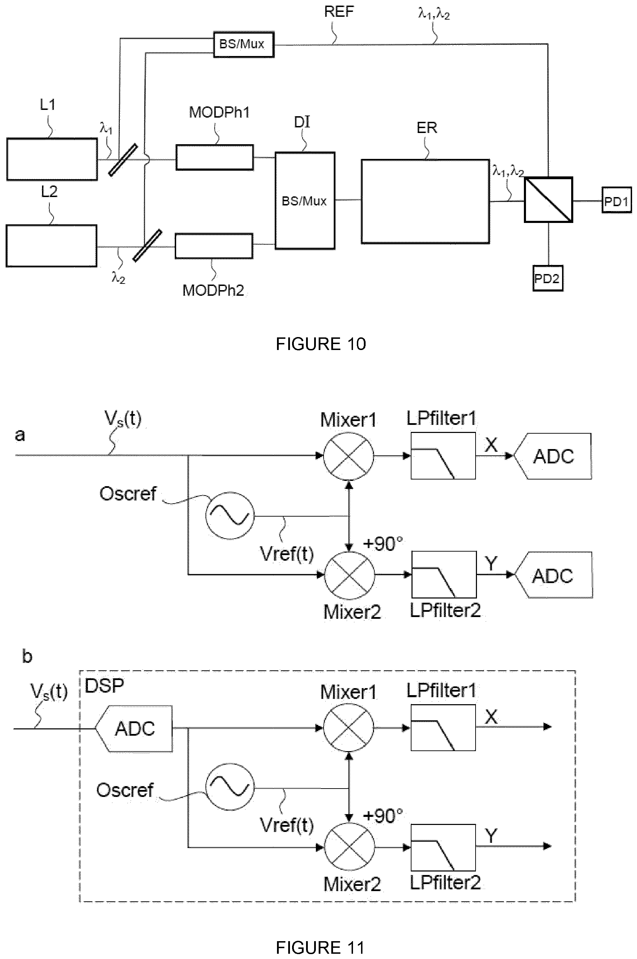

La modulation d'intensité par un interféromètre March Zender MZ est une méthode mixte. Le principe du modulateur Mach Zender consiste à scinder en deux un faisceau initial qui parcourt deux branches dont la différence de phase $\Delta\Phi$ est contrôlée. En sortie deux faisceaux complémentaires en intensité sont obtenus à l'aide d'une séparatrice. L'application au dispositif de mesure selon l'invention est illustrée en figure 10 pour deux longueurs d'onde $\lambda1$ et $\lambda2$ générées respectivement par deux lasers L1, L2. On module la phase de l'onde optique d'une des branches de l'interféromètre, l'ensemble ER étant disposé sur une des branches, avec un modulateur de phase MODph1 pour le faisceau à $\lambda1$ et MODph2 pour le faisceau à $\lambda2$. Dans l'exemple de la figure 10 l'ensemble ER est disposé sur la même branche que les modulateurs de phase. Lors de la recombinaison du faisceau déphasé avec le faisceau de référence REF, la modulation de phase produit pour chaque faisceau optique à $\lambda i$ une modulation d'intensité. En sortie les signaux des photodiodes complémentaires PD1 et PD2 sont mesurés. On réalise alors un signal différentiel injecté dans le dispositif de démodulation. L'avantage est de gagner un facteur 2 dans le signal de sortie et d'éliminer les perturbations communes, comme par exemple les variations d'intensité laser, l'intensité statique, bruits etc... En outre cette configuration permet de minimiser la modulation d'intensité optique dans les résonateurs optiques. Cette modulation d'intensité peut générer par échauffement thermique localisé un signal de fond cohérent avec la modulation laser.

Enfin le système 10 comprend un dispositif de démodulation DDM comprenant au moins N modules de démodulation 11 de type détection synchrone pour démoduler le signal de sortie, de manière à extraire des signaux caractéristiques Sdemod(i,j) associés à chaque élément Eij, les valeurs mesurées uij de la grandeur physique u étant déterminées à partir des signaux caractéristiques.

Le principe du système selon l'invention est que l'information relative à une longueur d'onde $\lambda i$ est codée par une modulation de fréquence à fmod(i), permettant la récupération de cette information non pas par un démultiplexage en longueur d'onde mais par un traitement électronique de démodulation de type détection synchrone. Les signaux aux fréquences d'intérêt sont extraits électroniquement avec un très bon rapport signal sur bruit. L'extraction s'effectue par des blocs analogiques ou numériques.

On détermine la fonction de transmission de l'ensemble résonant :

$$tr(\lambda, u) = a_{out}/a_{in}$$

avec $a_{in}$ amplitude du faisceau *Bin* et $a_{out}$ amplitude du faisceau *Bout*, pour un $\lambda$ donné (faisceau monochromatique)..

En entrée l'onde optique d'entrée $a_{in}$ s'écrit :

$$a_{in} = a_{in1}e^{-j\omega1t} + a_{in2}e^{-j\omega2t} + \cdots$$

Avec $\omega i = 2\pi C/\lambda i$ la pulsation associée à $\lambda i$ (référencée dans le vide).

En sortie, en pratique seule une intensité optique $I_{out} = |a_{out}|^2$ est mesurable. On s'intéresse à de petites variations du paramètre u. La fonction de transmission peut être linéarisée :

$$t_{r}(\lambda_i, u_{ij}) = t_{r0}(\lambda_{i0})(1 + \alpha_{ij}.u_{ij}) \quad (1)$$

Avec $\alpha_{ij}$ nombre complexe, $u_{ij}$ valeur de u mesurée par le capteur Cij et $\alpha_i$.

Pour les capteurs résonants, un signal d'excitation est appliqué au capteur à $\Omega ij$ :
$u_{ij} = u_{ij0}(z).\cos(\Omega_{ij}t + \phi_{ij}(z))$ avec z mesurande d'intérêt, et $\Omega ij$ pulsation caractéristique :

$$\Omega_{ij} = 2.\pi.fc(i,j)$$

L'équation 1 devient :

$$t_r\,(\lambda_i,\,u_{ij})\;=\;t_{r0}(\lambda_i)_{\cdot}\,[1 + \alpha_i . u_{ij0}(z)\cos(\Omega_{ij}t + \phi_{ij}(z))] \qquad (2)$$

Ceci est également valable pour une mise en vibration naturelle.

Par exemple on s'intéresse au déphasage $\phi i(z)$ par rapport à la source d'excitation

$$F_{ij} = F_{ij0}\cos(\Omega_{ij}t)$$

Le signal optique en sortie correspond à la superposition des réponses de chaque capteur optique:

$$a_{out} = a_{in1}e^{-j\omega 1t}.tr(\lambda_1, u_{11}) + a_{in1}e^{-j\omega 1t}.tr(\lambda_1, u_{12}) + a_{in1}e^{-j\omega 1t}.tr(\lambda_1, u_{13}) \ldots$$

$$+ a_{in2}e^{-j\omega 2t}.tr(\lambda_2, u_{21}) + a_{in2}e^{-j\omega 2t}.tr(\lambda_2, u_{22}) \ldots$$

$$+ a_{in3}e^{-j\omega 3t}.tr(\lambda_3, u_{31}) + \ldots$$

Avec la linéarisation, on démontre que le signal d'intensité optique en sortie comporte des composantes :

$$I_{out} \propto I1.\cos(\Delta 1).[1+\alpha_{11}(\lambda)\cos(\Omega_{11})u_{11}(t) + \alpha_{12}(\lambda)\cos(\Omega_{12})u_{12}(t) + \ldots]$$

$$+ I2.\cos(\Delta 2).[1+\alpha_{21}(\lambda)\cos(\Omega_{21})u_{21}(t) + \alpha_{22}(\lambda)\cos(\Omega_{22})u_{22}(t) + \ldots]$$

$$+ I3.\cos(\Delta 3).[1+\alpha_{31}(\lambda)\cos(\Omega_{31})u_{31}(t) + \alpha_{32}(\lambda)\cos(\Omega_{32})u_{32}(t) + \ldots] \quad \ldots \quad (3)$$

Avec $\Delta i = 2.\pi.fmod(i)$

Les ondes optiques de longueur d'onde différentes sont en effet incohérentes entre elles. Les termes d'intensité croisée oscillent à très haute fréquence et ont des différences de phase aléatoires : pour ces raisons, ils ont une moyenne nulle.

On voit sur la formule (3) que l'information d'intérêt uij est codée sur les composantes de $I_{out}$ de pulsation $\Delta i+/-\Omega ij$ (formule trigonométrique du produit des cosinus).

La formule (3) montre également que l'on peut positionner la modulation à $\Delta i$ en sortie de l'ensemble résonant, comme illustré en figure 9. Il s'agit toujours de multiplier une amplitude optique complexe par une fonction de modulation complexe et par une fonction de transmission complexe du résonateur optique. L'ordre des opérations est interchangeable.

L'utilisation d'une détection synchrone aux pulsations $\Delta i+\Omega ij$ ou $\Delta i-\Omega ij$ génère un signal Sdemod(i,j) proportionnel à $\alpha_{ij}(\lambda).u_{ij}(t)$ (première architecture). Un résultat similaire est obtenu avec une démodulation à $\Delta i$ suivi d'un filtrage spectral ou d'une deuxième démodulation à $\Omega ij$ (deuxième architecture dite à deux étages).

Les inventeurs ont ainsi montré que grâce à la linéarisation des fonctions de transmission, les signaux d'intérêt sont accessibles par un codage/décodage de type modulation/démodulation selon l'invention.

L'utilisation d'une détection synchrone permet d'extraire directement le signal de phase avec un très bon SNR. Dans le cas des capteurs résonants, il s'agit souvent de l'information à extraire.

Les avantages du système de mesure selon l'invention sont multiples:

Les signaux démodulés Sdemod(i,j) permettent d'isoler les mesurandes associés à chaque capteur photonique Cij individuel car les signaux sont positionnés sur des bandes spectrales différentes.

Chaque longueur d'onde « récolte » de l'information localisée dans la puce photonique au niveau de chaque résonateur optique.

La lecture de l'information issue des différents capteurs est simultanée.

Contrairement au mux/demux en longueur d'onde, la reconfiguration du démultiplexage est aisée :

- il s'agit de modifier les fréquences des oscillateurs fmod(i) pilotant les modulateurs dans l'électronique de contrôle,

- un choix judicieux d'un jeu de fréquences fmod(i) permet d'assurer une bonne séparation des signaux.

Pour que le système fonctionne, il convient que les fréquences caractéristiques fc(i,j) soient différentes les unes des autres pour tous les j d'un même résonateur optique Ri. La situation $\Delta_1 + \Omega_{11} = \Delta_2 + \Omega_{21}$ peut être évitée par un choix approprié de $\Delta_1$ et $\Delta_2$.

Le principe mis en oeuvre ici permet de positionner les signaux associés à chaque résonateur optique dans des bandes de fréquences arbitraires que l'on peut éloigner aisément lorsque l'on fixe les pulsations $\Delta_i$.

Le filtre passe bas de bande passante $BP_{LIA}$ intégré à la détection synchrone et disposé en sortie du canal de démodulation $i$ du LIA (voir § suivants et figure 11) permet d'éliminer les autres composantes éloignées de $\Delta_j - \Delta_i \gg BP_{LIAi}$.

Plus précisément pour le canal de démodulation à $\Delta_i + /\Omega_{ij}$, il faut faire en sorte que toutes les composantes de signal $\Delta_i' + /- \Omega_i'_{j'}$ différentes de la fréquence ci-dessus soient suffisamment éloignées : typiquement plusieurs fois la bande passante $BP_{LIA}$ du canal concerné.

Cette condition peut être obtenue très simplement compte tenue de la bande de mesure désirée. Les EOM actuels ont des fréquences de travail qui peuvent atteindre les 40-100 GHz.

La détection synchrone est une technique de traitement du signal hétérodyne bien connue qui permet l'extraction d'un signal de faible amplitude et de bande étroite de fréquence connue dans un signal d'entrée large bande Vs(t) le cas échéant bruité. Egalement dénommée démodulation cohérente, elle comprend classiquement un oscillateur de référence Oscref générant un signal de référence Vref(t) sinusoïdal à une fréquence proche de la fréquence moyenne à détecter fref, un mélangeur multipliant le signal d'entrée par le signal de référence et un intégrateur qui intègre le signal multiplié sur une période très supérieure à celle du signal à détecter ou du signal d'entrée, de manière à extraire le signal utile de fréquence fs=fref.

Pratiquement elle est mise en oeuvre par un Amplificateur à Détection Synchrone ADS, ou« Lock In Amplifier » (LIA) en terminologie anglo-saxonne. Le signal est amplifié et multiplié par la référence (oscillateur interne ou externe). Un filtre passe bas de fréquence de coupure adaptée réalise l'intégration. La détection synchrone peut être réalisée de manière analogique ou numérique.

La présence de ce filtre passe bas de bande passante $BP_{LIA}$ est essentielle dans le processus de multiplexage. C'est lui qui permet de ne conserver que certaines composantes de signal en sortie (séparation des signaux pour le démultiplexage).

Selon une version améliorée un module de démodulation cohérente ou LIA 11 comprend deux voies en quadrature telle qu'illustré en figure 11. Il comprend un oscillateur de référence Oscref, une première chaine de démodulation comprenant un mélangeur Mixer1 et un filtre passe bas LPfilter1, et une deuxième chaine de démodulation (Mixer2, LPfilter2), les deux signaux injectés dans les deux mélangeurs étant déphasés de $\pi/2$. Pour le cas analogique (11 a) les deux quadratures X et Y sont numérisées via des blocs ADC pour Analogie Digital Converter. En numérique (11 b) le signal d'entrée est numérisé par un bloc ADC. L'amplitude et la phase du signal recherché à la fréquence fref sont déterminées à partir de X et Y. La détection en quadrature permet l'accès à la phase et un calcul exact de l'amplitude. La fréquence fref, qui correspond à la fréquence du signal extrait par le module de démodulation cohérente 11, est dénommée fréquence de démodulation.

Le nombre de modules de démodulation LIA 11 et le choix des différentes fréquences de modulation et de démodulation dépendent du type de capteurs de l'ensemble ER et de l'architecture de démodulation choisie, comme expliqué ci-après.

Au niveau du réseau de capteurs, selon un mode de réalisation au moins un élément Eij est résonant et présente une fréquence caractéristique fc(i,j), et selon un sous mode de réalisation au moins un résonateur optique Ri comprend une pluralité d'éléments résonants Eij (il existe au moins un i pour lequel j >1). La fréquence caractéristique est soit une fréquence de vibration naturelle induite par la grandeur physique à mesurer, soit une fréquence d'excitation externe de l'élément, comme expliqué dans l'état de la technique. La présence ou pas d'une fréquence caractéristique pour les éléments a des conséquences sur le choix des fréquences de démodulation.

On définit un bande passante BPc(i,j) du capteur Eij/Ri correspondant aux signaux issus du capteur. Elle est centrée autour de fc lorsque fc existe et est constituée d'un intervalle entre 0Hz et une fréquence fmax pour un capteur sans fréquence caractéristique.

De manière générale pour éliminer les fréquences parasites il convient que la fréquence de démodulation soit très supérieure (par exemple 10 fois) à la bande passante du filtre passe bas du LIA $BP_{LIA}$.

$$fdemod(i) > 10. \ BP_{LIA}$$

En outre pour bien isoler les différents canaux il convient que la distance entre deux fréquences de démodulation soit très supérieure (par exemple 10 fois) à $BP_{LIA}$ :

$$fdemod(i) - fdemod(j) > 10.BP_{LIA}$$

Cependant avec un résonateur mécanique de bande passante BPc, l'utilisateur peut accepter de réduire sa bande passante de mesure à un niveau inférieur, et régler la valeur de BP$_{LIA}$ à une valeur beaucoup plus faible que la différence ci-dessus, ce qui assure un excellent rejet du signal parasite dans chaque canal de détection.

Selon une première variante d'ensemble résonant, illustrée en figure 12 pour le cas N=3, un seul élément Ei est associé à chaque résonateur optique.

Dans un premier cas il s'agit de couches fonctionnalisées et/ou d'éléments mécaniques (poutres, plateaux, pointes) non résonants dont on mesure le degré de liberté x (x=u), comme décrits plus haut. Dans ce cas le dispositif de démodulation DDM comprend N modules de démodulation LIA configurés pour opérer N démodulations aux fréquences de modulation fmod(i) :

$$I_{out} \propto I1.\cos(\Delta 1).[1+\alpha_1(\lambda)u_1(t)] + I2.\cos(\Delta 2).[1+\alpha_2(\lambda)u_2(t)] + I3.\cos(\Delta 3).[1+\alpha_3(\lambda)u_3(t)]$$

$$+...$$

L'oscillateur de référence de chaque canal i Oscref(i) pour la génération de la fréquence de démodulation est préférentiellement commun à la modulation, pour assurer la cohérence entre la modulation et la démodulation et éviter la dérive de phase dans le temps Oscs(i) = Oscref(i). Ainsi la fréquence de démodulation est synthétisée à partir de la fréquence de modulation, ce qui est illustré par le bloc Synchro sur la figure 12.

De manière générique on considère qu'une fréquence est générée à partir d'un oscillateur. La fréquence de démodulation est donc générée à partir de l'oscillateur source générant la fréquence de modulation.

De manière générique lorsque le traitement de la démodulation est numérique, on utilise préférentiellement une même horloge de synthèse pour synchroniser les différents oscillateurs (modulation et démodulation).

Dans un deuxième cas au moins un élément Ei est résonnant à une fréquence caractéristique fc(i). L'élément peut être confondu avec le résonateur optique (voir état de la technique).

La formule (3) s'écrit :

$$I_{out} \propto I1.\cos(\Delta 1).[1+\alpha_1(\lambda)\cos(\Omega_1)u_1(t) + I2.\cos(\Delta 2).[1+\alpha_2(\lambda)\cos(\Omega_2)u_2(t)$$

$$+ I3.\cos(\Delta 3).[1+\alpha_3(\lambda)\cos(\Omega_3)u_3(t)$$

Selon un premier mode de réalisation, le dispositif de démodulation DDM comprend N modules de démodulations LIA configurés pour opérer respectivement N démodulations aux fréquences fdemod(i) égales à fmod(i)+/- fc(i) lorsque fc(i) existe, et aux fréquences fmod(i) sinon. On choisit la fréquence de démodulation : soit fmod(i)+fc(i), soit fmod(i)-fc(i) (en valeur absolue). Cette architecture est dénommée « à un étage ».

Il peut être avantageux dans certains cas de préférer une chaine de conditionnement de signal basse fréquence : moindre consommation énergétique, meilleur SNR pour les photodiodes par exemple. Dans ce cas de figure, on peut faire le choix de la fréquence de démodulation de valeur absolue la plus petite. Pour cela, on choisira fmod de telle sorte que fmod - fc soit dans la bande passante de la chaine de conditionnement. On entend par chaine de conditionnement l'ensemble de la chaîne de traitement entre la détection et la détermination de la grandeur souhaitée.

Préférentiellement lorsque la fréquence caractéristique fc est une fréquence d'excitation fex, la fréquence de démodulation est synthétisée à partir de l'oscillateur source générant la fréquence de modulation, et à partir d'un oscillateur d'excitation générant la fréquence d'excitation associée. Lorsque la fréquence caractéristique est une vibration naturelle, selon un mode de réalisation la fréquence naturelle à mesurer est détectée (« track » en anglais) et utilisée pour synthétiser la fréquence de démodulation, en combinaison avec la fréquence de modulation.

Dans cette architecture à un étage on veille à ce que la BP$_{LIA}$ soit toujours inférieure ou égale à BPc. Si BP$_{LIA}$ est supérieure, c'est le capteur lui-même qui impose la bande passante.

La figure 13 illustre l'exemple d'un ensemble résonant comprenant 3 disques constituant à la fois le résonateur optique et le résonateur mécanique. Les trois disques sont excités respectivement aux fréquences fex(1), fex(2) et fex(3), générées respectivement par 3 oscillateurs Oscex1, Oscex2, Oscex3. Les trois fréquences d'excitation sont respectivement comprises dans les bandes spectrales mécaniques BPm1, BP2m, BP3m autour des fréquences de résonance mécaniques frm1, frm2, frm3. Les signaux V1(t), V2(t) et V3(t) issus des oscillateurs sont transportés sur un même bus et injectés aux trois disques, chaque disque opérant un filtre et ne réagissant qu'à sa résonance propre. Les fréquences de modulation fmod(1), fmod(2) et fmod(3) sont générées respectivement par trois oscillateurs sources Oscs1, Oscs2, Oscs3. La fréquence de démodulation fdemod(i) = fmod(i)+/-fex(i) est synthétisée à partir des deux signaux issus des deux oscillateurs Oscsi et Oscexi.

Les fréquences de modulation sont typiquement choisies entre quelques KHz et quelques GHz.

Prenons l'exemple de deux faisceaux à λ1, λ2 modulés respectivement aux fréquences fmod(1) et fmod(2), associés à deux résonateurs optiques R1 et R2. Les deux capteurs R1/E1 et R2/E2 présentent des fréquences d'excitation respectives fex(1)=100 MHz et fex(2)=101 MHz et des bandes passantes de résonance mécanique sensiblement identiques BPm1,2 = 10 kHz. La bande passante du capteur BPc est limitée par la bande passante mécanique BPm. En pratique BPc ≤ BPm. On prend BPc = BPm.

On choisit les fréquences de modulations fmod(1) =99 MHz et fmod(2)=99.5 MHz, ce qui conduit à des fréquences de démodulation :

$$\text{fdemod}(1) = \text{fmod}(1) - \text{fex}(1) = 100\text{MHz} - 99\text{MHz} = 1 \text{ MHz}$$

$$\text{fdemod}(2) = \text{fmod}(2) - \text{fex}(2) = 101\text{MHz} - 99.5 \text{ Mz} = 1.5 \text{ MHz}$$

On peut prendre $\text{BP}_{\text{LIA}}$= BPc=10kHz. Prendre une bande passante $\text{BP}_{\text{LIA}}$ supérieur a peu d'intérêt car le capteur est limité lui-même à 10kHz.

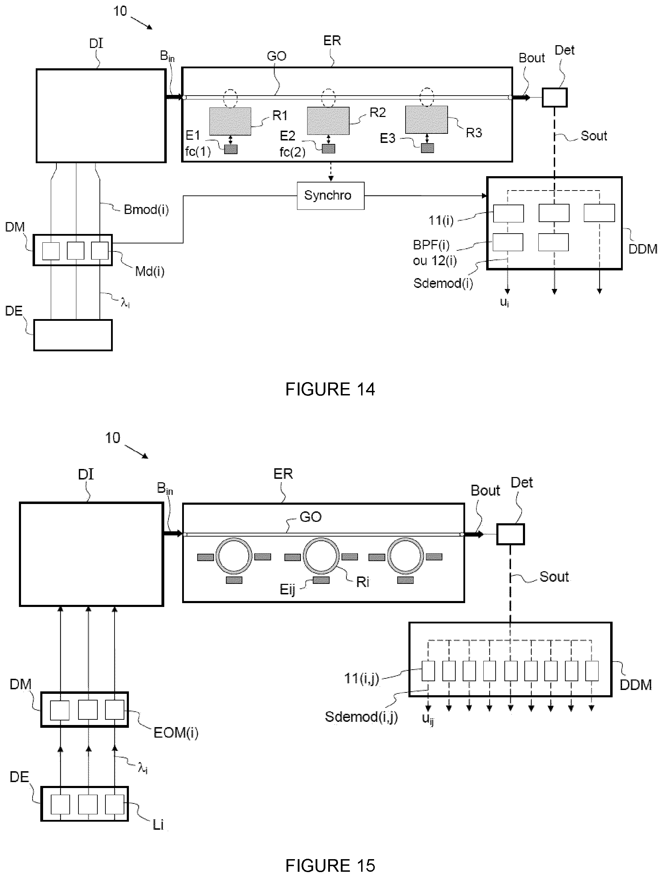

Dans le cas pour lequel au moins un élément Ei est résonnant à une fréquence caractéristique fc(i), selon un deuxième mode de réalisation, dit à deux étages, illustré en figure 14 pour N=3, le dispositif de démodulation DDM comprend un premier étage de N modules de démodulations LIA (11) configurés pour opérer respectivement N démodulations aux fréquences fdemod(i) = fmod(i), et un deuxième étage.

Le deuxième étage comprend :

- soit des filtres spectraux BPF(i) configurés pour opérer, pour chaque canal i pour lequel la fréquence fc(i) existe, un filtrage spectral autour de fc(i) pour extraire le signal caractéristique associé,

- soit des démodulateurs LIA 12(i) aux fréquences fc(i). Dans ce cas la synchronisation Synchro de DM vers DDM intègre également des informations issues des fréquences fc(i).

Le choix entre filtres spectraux et démodulateurs LIA est fonction du signal que l'on recherche. S'il s'agit d'une enveloppe temporelle des filtres spectraux suffisent, si l'on recherche une information précise sur l'amplitude et la phase du signal, des démodulateurs LIA doivent être utilisés.

Dans l'exemple figure 14 les résonateurs R1 et R2 ont chacun un élément E1, E2, de fréquence caractéristique respective fc(1) et fc(2), et le résonateur R3 n'a pas de fréquence caractéristique. Les canaux 1 et 2 comprennent respectivement un filtre BPF(1) et BPF(2) et pas le canal 3. En effet pour ce canal 3 le signal issu de E3 a déjà été filtré par le démodulateur LIA 11(3) du premier étage. Un filtre passe bas peut être inséré de manière optionnelle après 11(3) pour améliorer le filtrage.

Un avantage de ce dispositif à deux étages est que l'oscillateur de référence est synchronisé sur l'oscillateur source uniquement. L'oscillateur de référence utilisé pour la démodulation est dans ces conditions parfaitement cohérent avec le signal à analyser. La démodulation est ainsi réalisée sans erreur de phase ou dérive de phase.

Les fréquences de modulation sont typiquement choisies entre quelques dizaines de KHz et quelques GHz.

Cette fois-ci, on choisit préférentiellement une $\text{BP}_{\text{LIA}}$ telle que :

$$\text{BP}_{\text{LIA}} > \text{fc} + \text{BPc}$$

En effet $\text{BP}_{\text{LIA}}$ doit laisser passer tous les signaux issus des capteurs et doit donc contenir le spectre entier du signal capteur à partir de 0 Hz. Cette condition est plus contraignante que pour l'architecture à un étage.

Prenons l'exemple de deux faisceaux à λ1, λ2 associés à deux résonateurs optiques R1 et R2 de fréquence de modulation fmod(1) et fmod(2). Il n'y a qu'un seul élément par capteur. Les deux capteurs R1/E1 et R2/E2 présentent des fréquences d'excitation respectives fex(1)=10 MHz et fex(2)=11 MHz et des bandes passantes de résonance mécanique sensiblement identiques BPm1,2 = 10 kHz.

On choisit les fréquences de modulations / démodulation et une bande passante de LIA $\text{BP}_{\text{LIA}}$ de 20 MHz :

$$\text{fmod}(1) =1 \text{ GHz} ; \quad \text{fmod}(2)=1.5 \text{ GHz},$$

Cette architecture requiert des fréquences de modulation plus élevée que pour le cas précédent : elle doit être supérieure à fc et préférentiellement 10 x fc :

fmod> 10.fc

Dans le cas précédent il n'y a pas cette condition.

Selon une deuxième variante d'ensemble résonant, au moins un résonateur optique comprend une pluralité d'éléments associés Eij dont des éléments résonants. Un résonateur Ri comprenant Mi éléments associés et l'ensemble résonnant ER comprend un total de M éléments Eij.

Ces éléments sont par exemple des poutres ou des plateaux. Lorsque plusieurs éléments sont associés à un même résonateur, il convient que chaque élément présente une fréquence caractéristique différente pour pouvoir être discriminé des autres éléments du même résonateur.

Selon un premier mode de réalisation, à un étage, le dispositif de démodulation comprend M modules de démodulation LIA configurés pour opérer respectivement M démodulation aux fréquences fmod(i) +/- fc(i,j) lorsque fc(i,j) existe, et aux fréquences fmod(i) sinon. L'avantage est que cette l'architecture ne comprend qu'un seul étage, l'information étant obtenue par un seul traitement. La contrainte du choix des fréquences de modulation est qu'elle doit être préférentiellement supérieure à 10 fois la bande passante du capteur.

La figure 15 illustre ce premier mode de réalisation pour le cas N=3 et Mi=3 pour tous les résonateurs Ri, soit M=9. Le dispositif de démodulation comprend dans ce cas 9 démodulateurs LIA 11(i,j) .

La figure 16 illustre ce premier mode de réalisation pour un cas mixte avec N=3 dans lequel le premier résonateur R1 comprend 3 éléments résonants E11, E12,et E13, le deuxième résonateur R2 comprend un seul élément résonant E21, et le troisième résonateur R3 comprend un élément non résonant E31. Dans ce cas le dispositif de démodulation DDM comprend 5 démodulateurs LIA respectivement aux fréquences de démodulation : fmod+fc11, fmod+fc12, fmod+fc13, fmod+fc21, fmod.

Le choix des différents paramètres obéit aux mêmes conditions qu'explicité précédemment pour le cas à un étage de la première variante.

Cette architecture à un étage est préférée lorsque l'on souhaite mesurer l'amplitude et la phase du signal du capteur.

Selon un deuxième mode de réalisation appliqué à la deuxième variante d'ensemble résonant, le dispositif de démodulation DDM comprend un premier étage comprenant N modules de démodulation LIA configurés pour opérer respectivement N démodulations aux fréquences fmod(i) et comprend, pour chaque canal i pour lequel au moins une fréquence caractéristique existe, un deuxième étage.

Un avantage est, pour une démodulation haute fréquence (au GHz par exemple), de n'effectuer que N démodulations haute fréquence, avec un deuxième étage dédié à des modules basse fréquence. On a ainsi un nombre inférieur de démodulations haute fréquence que pour le cas à un seul étage.

Selon une première option le deuxième étage comprend des modules de démodulation LIA 12 aux fréquences caractéristiques fc(i,j). Pour les éléments non résonants on utilise un filtre passe bas.

Selon une deuxième option le deuxième étage comprend des filtres spectraux BPF configurés pour opérer un filtrage spectrale autour de la fréquence caractéristique fc(i,j). De même pour les éléments non résonants on utilise un filtre passe bas.

Ici également le choix entre les deux options dépend du signal à extraire (voir précédemment).

La figure 17 illustre le cas de N=3 avec Mi=3 pour tous les i. On a un premier étage de 3 démodulateurs LIA 11(1), 11(2), 11(3) aux fréquences respectives fmod(1), fmod(2) et fmod(3) et un deuxième étage qui comprend 9 démodulateurs LIA ou 9 filtres spectraux, 3 (Mi) par résonateur Ri.

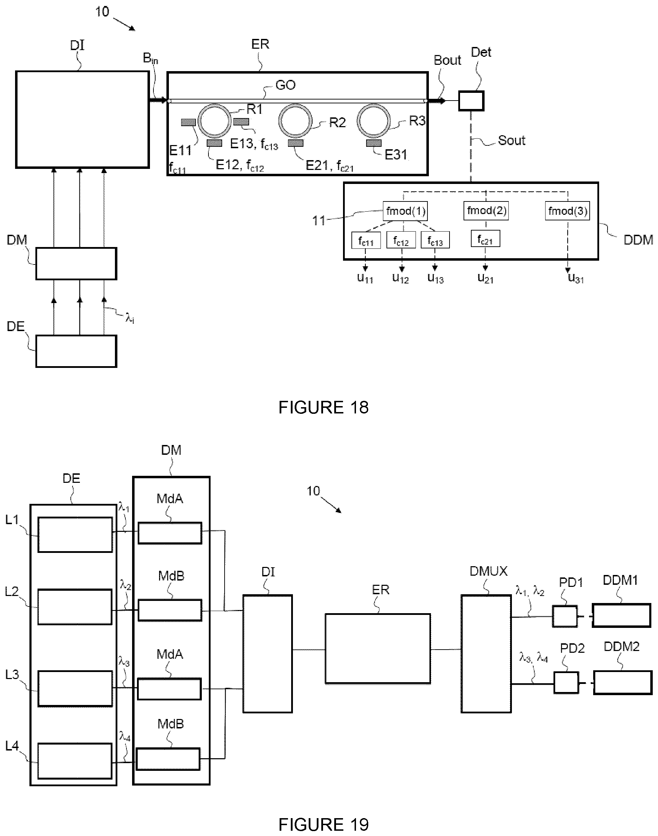

La figure 18 illustre l'ensemble ER mixte décrit précédemment et une architecture de démodulation à deux étages. On a dans ce cas toujours les 3 démodulateurs LIA pour le premier étage, et pour le deuxième étage :

- pour le résonateur R1 : soit 3 démodulateurs LIA à fc11, fc12, fc13, soit trois filtres spectraux centrés sur ces fréquences

- pour le résonateur R2 : soit un démodulateur LIA à fc21 soit un filtre spectral centré sur fc21.

- aucun deuxième étage pour le résonateur R3. Cependant si le résonateur R3 comprenait, en plus de l'élément sans fréquence caractéristique, un autre élément E32 avec une fréquence caractéristique, il conviendrait d'insérer un deuxième étage comprenant un filtre passe bas pour extraire le signal du capteur E31/R3, et un filtre passe bande ou un démodulateur LIA pour extraire le signal du capteur E32/R3.

L'avantage de l'architecture à 2 étages est que la démodulation du premier étage s'effectue aux fréquences fmod(i). La génération de la fréquence de démodulation est simplifiée puisqu'elle est égale à la fréquence de modulation, les deux fréquences fmod(i) et fdemod(i) étant synthétisée à partir du même oscillateur source.

Le choix des différents paramètres obéit aux mêmes conditions qu'explicité précédemment pour le cas deux étages de la première variante, et il convient donc de choisir des fréquences de modulation assez élevées pour garantir un filtrage efficace entre canaux.

Par exemple on considère le cas de deux résonateurs R1 et R2 et des capteurs R1/E11, R1/E12, R2/E21 et R2/E22. On a : fex(11) = 5 MHz, fex(12) = 6 MHz, fex(21) = 5 MHz et fex(22) = 0 Hz. On suppose que les bandes passantes des capteurs BPc sont toutes à 10 kHz. On peut prendre fmod(1) = 100 MHz et fmod(2) = 200 MHz et des filtres LIA de $BP_{LIA}$= 10 MHz.

Le démodulateur 11(1) à fdemod = 100 MHz permet d'isoler les signaux de R1/E11 et R1/E12, tous les deux situés à 5 et 6 MHz. Un deuxième étage permet ensuite d'extraire, plus précisément de séparer, l'amplitude et la phase avec des modules LIA ou la forme d'onde avec des filtres passe bande : la largeur de filtrage peut peut-être choisie à 10 kHz ou en dessous. Le démodulateur 11(2) fait la même chose pour les signaux à 5 MHz et 0 Hz.

Selon un mode de réalisation le système de mesure selon l'invention est combiné avec un dispositif de démultiplexage en longueur d'onde, tel qu'illustré en figure 19. Cela permet de lever la contrainte d'avoir des fréquences de modulation toutes différentes.

Les lasers L1 et L3 sont modulés, via un modulateur respectif MdA, à une même fréquence fmodA, de même que les lasers L2 et L4 sont modulés, via MdB, à une même fréquence fmodB. Le dispositif d'injection superpose tous les faisceaux et les injecte dans l'ensemble résonant ER. En sortie un composant démultiplexeur DMUX est ajouté, qui sépare d'une part les faisceaux à λ1 et λ2 qui sont détectés par PD1 et d'autre part les faisceaux à λ3 et λ4 qui sont détectés par PD2. Chaque détecteur PD1, PD2 est couplé à un dispositif de démodulation, respectivement DDM1, DDM2. Le traitement des signaux portés par λ1 et λ2 s'effectue de manière indépendante du traitement des signaux portés par λ3 et λ4.

On peut en outre atteindre un plus grand nombre de canaux dans le système.

## Revendications

1. Système de mesure (10) de type MEMs et/ou NEMs comprenant :

   - un ensemble résonnant (ER) comprenant :

     • une entrée (E) et une sortie (S),
     • une pluralité de N résonateurs optiques Ri indicés i présentant chacun une longueur d'onde de résonance λr,i,
     • au moins un guide d'onde (GO) auquel sont couplés les résonateurs optiques,
     • au moins un élément (Ei, Eij) couplé à chaque résonateur Ri et configuré pour modifier une transmission ou une réflexion optique au voisinage de la résonance dudit résonateur optique, ladite modification étant fonction d'une grandeur physique (u) à mesurer,

   le système de mesure étant **caractérisé en ce qu'**il comprend par ailleurs: H

     - un dispositif d'émission (DE) configuré pour émettre une pluralité de N faisceaux lumineux présentant chacun une longueur d'onde d'émission λi comprise dans la bande de résonance du résonateur optique associé,
     - un dispositif de modulation (DM) configuré pour moduler chacun des faisceaux lumineux à une fréquence de modulation fmod(i),
     - un dispositif d'injection (DI) configuré pour superposer les N faisceaux lumineux pour former un faisceau d'entrée (Bin) et pour injecter le faisceau en entrée de l'ensemble résonant,
     - au moins un détecteur (Det) configuré pour détecter un faisceau lumineux issu du faisceau en sortie de l'ensemble résonant (Bout) et générer un signal de sortie (Sout),
     - un dispositif de démodulation (DDM) comprenant au moins N modules de démodulation (11) de type détection synchrone, dénommé LIA, pour démoduler le signal de sortie, de manière à extraire des signaux caractéristiques (Sdemod(i,j)) associés à chaque élément, des valeurs mesurées (uij, zij) de ladite grandeur physique étant déterminées à partir desdits signaux caractéristiques.

2. Système de mesure selon la revendication précédente dans lequel le dispositif de modulation est disposé en amont du dispositif d'injection, la superposition des N faisceaux lumineux modulés (Bmod(i)) formant le faisceau d'entrée.

3. Système de mesure selon la revendication précédente dans lequel le dispositif d'émission comprend N lasers et le dispositif de modulation comprend N modulateurs disposés respectivement sur les trajets optiques des N faisceaux lumineux émis par les N lasers, chaque modulateur étant configuré pour moduler le faisceau lumineux associé à la fréquence fmod(i).

4. Système de mesure selon la revendication précédente dans lequel les modulateurs sont des modulateurs électrooptiques.

5. Système de mesure selon la revendication 2 dans lequel le dispositif d'émission et le dispositif de modulation forment un même dispositif comprenant N lasers modulés en intensité.

6. Système de mesure selon l'une des revendications précédentes dans lequel un module de démodulation LIA comprend un oscillateur de référence à une fréquence de démodulation et une première chaine de démodulation comprenant un mélangeur et un filtre passe bas.

7. Système de mesure selon la revendication 6, dans lequel un module de démodulation LIA comprend une deuxième chaine de démodulation en quadrature avec la première chaine.

8. Système selon l'une des revendications précédentes dans lequel le résonateur optique est choisi parmi : un disque, un guide rebouclé sur lui-même, un cristal photonique.

9. Système de mesure selon l'une des revendications précédentes dans lequel un seul élément (Ei) est associé à chaque résonateur optique et dans lequel le dispositif de démodulation comprend N modules de démodulation LIA configurés pour opérer N démodulations auxdites fréquences de modulation fmod(i).

10. Système de mesure selon l'une des revendications 1 à 8 dans lequel au moins un élément Eij est résonnant et présente une fréquence caractéristique fc(i,j) comprise dans une bande de résonance de l'élément résonant Eij, j étant l'indice de l'élément associé au résonateur Ri.

11. Système de mesure selon la revendication 10 dans lequel un seul élément (Ei) est associé à chaque résonateur optique et dans lequel le dispositif de démodulation comprend N modules de démodulations LIA configurés pour opérer respectivement N démodulations aux fréquences fmod(i) +/- fc(i) lorsque fc(i) existe et aux fréquences fmod(i) sinon.

12. Système de mesure selon la revendication 10 dans lequel un seul élément (Ei) est associé à chaque résonateur optique et dans lequel le dispositif de démodulation comprend un premier étage de N modules de démodulations LIA (11) configurés pour opérer respectivement N démodulations aux fréquences fmod(i), et un deuxième étage comprenant soit des filtres spectraux (BPF) configurés pour opérer, pour chaque canal i pour lequel la fréquence fc(i) existe, un filtrage spectral autour de fc(i) pour extraire le signal caractéristique associé, soit des démodulateurs LIA aux fréquences fc(i).

13. Système de mesure selon la revendication précédente dans lequel l'élément est confondu avec le résonateur optique.

14. Système de mesure selon la revendication 10 dans lequel au moins un résonateur optique comprend une pluralité d'éléments associés Eij comprenant des éléments résonants, un résonateur Ri comprenant Mi éléments associés, l'ensemble résonnant (ER) comprenant un total de M éléments.

15. Système selon la revendication précédente dans lequel le dispositif de démodulation comprend M modules de démodulation LIA configurés pour opérer respectivement M démodulation aux fréquences fmod(i) +/- fc(i,j) lorsque fc(i,j) existe et aux fréquences fmod(i) sinon.

16. Système de mesure selon la revendication 14 dans lequel le dispositif de démodulation comprend un premier étage comprenant N modules de démodulation LIA configurés pour opérer respectivement N démodulation aux fréquences fmod(i) et comprend, pour chaque canal i pour lequel au moins une fréquence caractéristique existe, un deuxième étage comprenant des modules de démodulation LIA (11) aux fréquences caractéristiques fc(i,j).

17. Système de mesure selon la revendication 14 dans lequel le dispositif de démodulation comprend un premier étage comprenant N modules de démodulation LIA configurés pour opérer respectivement N démodulation aux fréquences fmod(i) et comprend, pour chaque canal i pour lequel au moins une fréquence caractéristique existe, un deuxième étage comprenant des filtres spectraux (BPF) configurés pour opérer un filtrage spectrale autour de la fréquence caractéristique fc(i,j).

**18.** Système de mesure selon l'une des revendications 10 à 17 dans lequel la fréquence caractéristique est une fréquence de vibration naturelle induite par la grandeur physique à mesurer.

**19.** Système de mesure selon l'une des revendications 10 à 17 dans lequel la fréquence caractéristique est une fréquence d'excitation externe dudit élément.

**20.** Procédé de mesure d'une grandeur physique (u) comprenant les étapes consistant à :

A émettre une pluralité de N faisceaux lumineux présentant chacun une longueur d'onde d'émission $\lambda_i$,
B moduler chacun des faisceaux lumineux à une fréquence de modulation fmod(i),
C superposer les N faisceaux lumineux pour former un faisceau d'entrée (Bin) et pour injecter le faisceau en entrée d'un l'ensemble résonant,
l'ensemble résonnant (ER) comprenant :

- une entrée (E) et une sortie (S),
- une pluralité de N résonateurs optiques Ri indicés i présentant chacun une longueur d'onde de résonance $\lambda_{r,i}$, la longueur d'onde $\lambda_i$ étant comprise dans la bande de résonance du résonateur optique Ri associé,
- au moins un guide d'onde (GO) auquel sont couplés les résonateurs optiques,
- au moins un élément (Ei, Eij) positionné au voisinage de chaque résonateur Ri

D modifier une transmission ou une réflexion optique au voisinage de la résonnance de chaque résonateur optique, ladite modification étant fonction de la grandeur physique (u) à mesurer,
E détecter un faisceau lumineux en sortie de l'ensemble résonnant et générer un signal de sortie,
F démoduler de manière synchrone le signal de sortie, à partir d'au moins N modules de démodulation de type détection synchrone, de manière à extraire des signaux caractéristiques (Sdemod(i,j)) associés à chaque élément, des valeurs mesurées (uij) de ladite grandeur physique étant déterminées à partir desdits signaux caractéristiques.

**Patentansprüche**

**1.** Messsystem (10) vom Typ MEMs und/oder NEMs, das Folgendes umfasst:

- eine Resonanzanordnung (ER), die Folgendes umfasst:

• einen Eingang (E) und einen Ausgang (S),
• eine Vielzahl von N optischen Resonatoren Ri mit Index i, die jeweils eine Resonanzwellenlänge $\lambda_{r,i}$ aufweisen,
• mindestens einen Wellenleiter (GO), mit dem die optischen Resonatoren gekoppelt sind,
• mindestens ein Element (Ei, Eij), das mit jedem Resonator Ri gekoppelt und zum Modifizieren einer optischen Transmission oder Reflexion in der Nähe der Resonanz des optischen Resonators konfiguriert ist, wobei die Modifikation von einer zu messenden physikalischen Größe (u) abhängt,

wobei das Messsystem **dadurch gekennzeichnet ist, dass** es ferner Folgendes umfasst:

- eine Emissionsvorrichtung (DE), die zum Emittieren einer Vielzahl von N Lichtstrahlen konfiguriert ist, von denen jeder eine Emissionswellenlänge $\lambda_i$ aufweist, die im Resonanzband des assoziierten optischen Resonators liegt,
- eine Modulationsvorrichtung (DM), die zum Modulieren jedes der Lichtstrahlen mit einer Modulationsfrequenz fmod(i) konfiguriert ist,
- eine Injektionsvorrichtung (DI), die zum Überlagern der N Lichtstrahlen zum Bilden eines Eingangsstrahls (Bin) und zum Injizieren des Strahls in den Eingang der Resonanzanordnung konfiguriert ist,
- mindestens einen Detektor (Det), der zum Erkennen eines Lichtstrahls aus dem Ausgangsstrahl der Resonanzanordnung (Bout) und zum Erzeugen eines Ausgangssignals (Sout) konfiguriert ist,
- eine Demodulationsvorrichtung (DDM), die mindestens N Demodulationsmodule (11) vom synchronen Detektionstyp, genannt LIA, zum Demodulieren des Ausgangssignals umfasst, um mit jedem Element assoziierte charakteristische Signale (Sdemod(i,j)) zu extrahieren, wobei Messwerte (uij, zij) der physikalischen Größe anhand der charakteristischen Signale bestimmt werden.

2. Messsystem nach dem vorhergehenden Anspruch, wobei die Modulationsvorrichtung der Injektionsvorrichtung vorgeschaltet ist, wobei die Überlagerung der N modulierten Lichtstrahlen (Bmod(i)) den Eingangsstrahl bildet.

3. Messsystem nach dem vorhergehenden Anspruch, wobei die Emissionsvorrichtung N Laser umfasst und die Modulationsvorrichtung N Modulatoren umfasst, die jeweils in den optischen Pfaden der von den N Lasern emittierten N Lichtstrahlen angeordnet sind, wobei jeder Modulator zum Modulieren des mit der Frequenz fmod(i) assoziierten Lichtstrahls konfiguriert ist.

4. Messsystem nach dem vorhergehenden Anspruch, wobei die Modulatoren elektrooptische Modulatoren sind.

5. Messsystem nach Anspruch 2, wobei die Emissionsvorrichtung und die Modulationsvorrichtung eine gemeinsame Vorrichtung bilden, die N intensitätsmodulierte Laser umfasst.

6. Messsystem nach einem der vorhergehenden Ansprüche, wobei ein LIA-Demodulationsmodul einen Referenzoszillator mit einer Demodulationsfrequenz und eine erste Demodulationskette umfasst, die einen Mischer und ein Tiefpassfilter umfasst.

7. Messsystem nach Anspruch 6, wobei ein LIA-Demodulationsmodul eine zweite Demodulationskette in Quadratur mit der ersten Kette umfasst.

8. System nach einem der vorhergehenden Ansprüche, wobei der optische Resonator aus: einer Scheibe, einer in sich geschlossenen Führung, einem photonischen Kristall ausgewählt ist.

9. Messsystem nach einem der vorhergehenden Ansprüche, wobei mit jedem optischen Resonator ein einzelnes Element (Ei) assoziiert ist und wobei die Demodulationsvorrichtung N LIA-Demodulationsmodule umfasst, die zum Durchführen von N Demodulationen bei den Modulationsfrequenzen fmod(i) konfiguriert sind.

10. Messsystem nach einem der Ansprüche 1 bis 8, wobei mindestens ein Element Eij resonant ist und eine charakteristische Frequenz fc(i,j) aufweist, die in einem Resonanzband des Resonanzelements Eij enthalten ist, wobei j der Index des mit dem Resonator Ri assoziierten Elements ist.

11. Messsystem nach Anspruch 10, wobei mit jedem optischen Resonator ein einzelnes Element (Ei) assoziiert ist und wobei die Demodulationsvorrichtung N LIA-Demodulationsmodule umfasst, konfiguriert zum jeweiligen Durchführen von N Demodulationen bei den Frequenzen fmod(i) +/- fc(i), wenn fc(i) existiert, und andernfalls bei den Frequenzen fmod(i).

12. Messsystem nach Anspruch 10, wobei mit jedem optischen Resonator nur ein Element (Ei) assoziiert ist und wobei die Demodulationsvorrichtung eine erste Stufe von N LIA-Demodulationsmodulen (11), die zum jeweiligen Durchführen von N Demodulationen bei den Frequenzen fmod(i) konfiguriert sind, und eine zweite Stufe umfasst, die entweder Spektralfilter (BPF), die so konfiguriert sind, dass sie für jeden Kanal i, für den die Frequenz fc(i) existiert, eine Spektralfilterung um fc(i) zum Extrahieren des assoziierten charakteristischen Signal durchführen, oder LIA-Demodulatoren bei den Frequenzen fc(i) umfasst.

13. Messsystem nach dem vorhergehenden Anspruch, wobei das Element mit dem optischen Resonator zusammenfällt.

14. Messsystem nach Anspruch 10, wobei mindestens ein optischer Resonator eine Vielzahl von Resonanzelementen umfassenden assoziierten Elementen Eij umfasst, wobei ein Resonator Ri Mi assoziierte Elemente umfasst, wobei die Resonanzanordnung (ER) insgesamt M Elemente umfasst.

15. System nach dem vorhergehenden Anspruch, wobei die Demodulationsvorrichtung M LIA-Demodulationsmodule umfasst, konfiguriert zum jeweiligen Durchführen von M Demodulationen bei den Frequenzen fmod(i) +/- fc(ij), wenn fc(ij) existiert, und andernfalls bei den Frequenzen fmod(i).

16. Messsystem nach Anspruch 14, wobei die Demodulationsvorrichtung eine erste Stufe, die N LIA-Demodulationsmodule umfasst, die so konfiguriert sind, dass sie jeweils N Demodulationen bei den Frequenzen fmod(i) durchführen, und für jeden Kanal i, für den mindestens eine charakteristische Frequenz existiert, eine zweite Stufe umfasst, die LIA-Demodulationsmodule (11) bei den charakteristischen Frequenzen fc(i,j) umfasst.

17. Messsystem nach Anspruch 14, wobei die Demodulationsvorrichtung eine erste Stufe, die N LIA-Demodulationsmodule umfasst, die so konfiguriert sind, dass sie jeweils N Demodulationen bei den Frequenzen fmod(i) durchführen, und für jeden Kanal i, für den mindestens eine charakteristische Frequenz existiert, eine zweite Stufe umfasst, die Spektralfilter (BPF) umfasst, die so konfiguriert sind, dass sie eine Spektralfilterung um die charakteristische Frequenz fc(i,j) durchführen.

18. Messsystem nach einem der Ansprüche 10 bis 17, wobei die charakteristische Frequenz eine natürliche Schwingungsfrequenz ist, die durch die zu messende physikalische Größe induziert wird.

19. Messsystem nach einem der Ansprüche 10 bis 17, wobei die charakteristische Frequenz eine externe Anregungsfrequenz des Elements ist.

20. Verfahren zum Messen einer physikalischen Größe (u), das die folgenden Schritte umfasst:

A Emittieren einer Vielzahl von N Lichtstrahlen, die jeweils eine Emissionswellenlänge $\lambda i$ aufweisen,
B Modulieren jedes der Lichtstrahlen mit einer Modulationsfrequenz fmod(i),
C Überlagern der N Lichtstrahlen zum Bilden eines Eingangsstrahls (Bin) und zum Injizieren des Strahls in den Eingang einer Resonanzanordnung,
wobei die Resonanzanordnung (ER) Folgendes umfasst:

- einen Eingang (E) und einen Ausgang (S),
- eine Vielzahl von N optischen Resonatoren Ri mit Index i, jeweils mit einer Resonanzwellenlänge $\lambda r,i$, wobei die Wellenlänge $\lambda i$ innerhalb des Resonanzbandes des assoziierten optischen Resonators Ri liegt,
- mindestens einen Wellenleiter (GO), mit dem die optischen Resonatoren gekoppelt sind,
- mindestens ein Element (Ei, Eij), das in der Nähe jedes Resonators Ri positioniert ist,

D Modifizieren einer optischen Transmission oder Reflexion in der Nähe der Resonanz jedes optischen Resonators, wobei die Modifikation von der zu messenden physikalischen Größe (u) abhängig ist,
E Erkennen eines Lichtstrahls am Ausgang der Resonanzanordnung und Erzeugen eines Ausgangssignals,
F synchrones Demodulieren des Ausgangssignals auf der Basis von mindestens N Demodulationsmodulen vom synchronen Detektionstyp zum Extrahieren von mit jedem Element assoziierten charakteristischen Signalen (Sdemod(ij)), wobei Messwerte (uij) der physikalischen Größe anhand der charakteristischen Signale bestimmt werden.

**Claims**

1. A MEMs and/or NEMs-type measurement system (10) comprising:

- a resonant assembly (ER) comprising:

• an input (E) and an output (S),
• a plurality of N optical resonators Ri indexed i, each having a resonance wavelength $\lambda r,i$,
• at least one waveguide (GO) to which the optical resonators are coupled,
• at least one element (Ei, Eij) coupled to each resonator Ri and configured to modify an optical transmission or reflection close to the resonance of said optical resonator, said modification being dependent on a physical quantity (u) to be measured,

the measurement system being **characterised in that** it further comprises:

- an emission device (DE) configured to emit a plurality of N light beams each having an emission wavelength $\lambda i$ in the resonance band of the associated optical resonator,
- a modulation device (DM) configured to modulate each of the light beams at a modulation frequency fmod(i),
- an injection device (DI) configured to superpose the N light beams to form an input beam (Bin) and to inject the beam as input to the resonant assembly,

- at least one detector (Det) configured to detect a light beam arising from the beam at the output of the resonant assembly (Bout) and to generate an output signal (Sout),
- a demodulation device (DDM) comprising at least N demodulation modules (11) of synchronous-detection type, denoted LIA, to demodulate the output signal, so as to extract characteristic signals (Sdemod(i,j)) associated with each element, measured values (uij, zij) of said physical quantity being determined from said characteristic signals.

2. The measurement system according to the preceding claim, wherein the modulation device is arranged upstream of the injection device, the superposition of the N modulated light beams (Bmod(i)) forming the input beam.

3. The measurement system according to the preceding claim, wherein the emission device comprises N lasers and the modulation device comprises N modulators arranged respectively on the optical paths of the N light beams emitted by the N lasers, each modulator being configured to modulate the light beam associated with the frequency fmod(i).

4. The measurement system according to the preceding claim, wherein the modulators are electro-optical modulators.

5. The measurement system according to claim 2, wherein the emission device and the modulation device form one and the same device comprising N intensity-modulated lasers.

6. The measurement system according to one of the preceding claims, wherein an LIA demodulation module comprises a reference oscillator at a demodulation frequency and a first demodulation chain comprising a mixer and a low-pass filter.

7. The measurement system according to claim 6, wherein an LIA demodulation module comprises a second demodulation chain in quadrature with the first chain.

8. The system according to one of the preceding claims, wherein the optical resonator is chosen from among: a disc, a guide looping back on itself, a photonic crystal.

9. The measurement system according to one of the preceding claims, wherein a single element (Ei) is associated with each optical resonator and wherein the demodulation device comprises N LIA demodulation modules configured to perform N demodulations at said modulation frequencies fmod(i).

10. The measurement system according to one of claims 1 to 8, wherein at least one element Eij is resonant and has a characteristic frequency fc(i,j) in a resonance band of the resonant element Eij, j being the index of the element associated with the resonator Ri.

11. The measurement system according to claim 10, wherein a single element (Ei) is associated with each optical resonator and wherein the demodulation device comprises N LIA demodulation modules configured to perform, respectively, N demodulations at the frequencies fmod(i) +/- fc(i) when fc(i) exists and at the frequencies fmod(i) otherwise.

12. The measurement system according to claim 10, wherein a single element (Ei) is associated with each optical resonator and wherein the demodulation device comprises a first stage of N LIA demodulation modules (11) configured to perform, respectively, N demodulations at the frequencies fmod(i), and a second stage comprising either spectral filters (BPF) configured to perform, for each channel i for which the frequency fc(i) exists, a spectral filtering around fc(i) to extract the associated characteristic signal, or LIA demodulators at the frequencies fc(i).

13. The measurement system according to the preceding claim, wherein the element is merged with the optical resonator.

14. The measurement system according to claim 10, wherein at least one optical resonator comprises a plurality of associated elements Eij comprising resonant elements, a resonator Ri comprising Mi associated elements, the resonant assembly (ER) comprising a total of M elements.

15. The system according to the preceding claim, wherein the demodulation device comprises M LIA demodulation modules configured to perform, respectively, M demodulations at the frequencies fmod(i) +/- fc(i,j) when fc(i,j) exists, and at the frequencies fmod(i) otherwise.

**16.** The measurement system according to claim 14, wherein the demodulation device comprises a first stage comprising N LIA demodulation modules configured to perform, respectively, N demodulations at the frequencies fmod(i) and comprises, for each channel i for which at least one characteristic frequency exists, a second stage comprising LIA demodulation modules (11) at the characteristic frequencies fc(i,j).

**17.** The measurement system according to claim 14, wherein the demodulation device comprises a first stage comprising N LIA demodulation modules configured to perform, respectively, N demodulations at the frequencies fmod(i) and comprises, for each channel i for which at least one characteristic frequency exists, a second stage comprising spectral filters (BPF) configured to perform spectral filtering around the characteristic frequency fc(i,j).

**18.** The measurement system according to one of claims 10 to 17, wherein the characteristic frequency is a natural vibration frequency caused by the physical quantity to be measured.

**19.** The measurement system according to one of claims 10 to 17, wherein the characteristic frequency is an external excitation frequency of said element.

**20.** A method for measuring a physical quantity (u) comprising the steps of:

A emitting a plurality of N light beams each having an emission wavelength $\lambda i$,
B modulating each of the light beams at a modulation frequency fmod(i),
C superposing the N light beams to form an input beam (Bin) and to inject the beam as input to the resonant assembly,
the resonant assembly (ER) comprising:

- an input (E) and an output (S),
- a plurality of N optical resonators Ri indexed i, each having a resonance wavelength $\lambda r,i$, the wavelength $\lambda i$ being in the resonance band of the associated optical resonator Ri,
- at least one waveguide (GO) to which the optical resonators are coupled,
- at least one element (Ei, Eij) positioned close to each resonator Ri,

D modifying an optical transmission or reflection close to the resonance of each optical resonator, said modification being dependent on the physical quantity (u) to be measured,
E detecting a light beam at the output of the resonant assembly and generating an output signal,
F synchronously demodulating the output signal, based on at least N synchronous-detection demodulation modules, so as to extract characteristic signals (Sdemod(i,j)) associated with each element, measured values (uij) of said physical quantity being determined from said characteristic signals.

FIGURE 1

FIGURE 2

FIGURE 3

FIGURE 4

FIGURE 5

FIGURE 6

FIGURE 7

10

DI   $B_{in}$   ER   Det   DDM

$\lambda_i$,Bmod(i)

DE + DM

Li

Sdemod(i,j)   $u_{ij}$

FIGURE 8

10

DI   ER   Bout   DM   Det   DDM

$\lambda_i$

DE

Sdemod(i,j)   $u_{ij}$

FIGURE 9

FIGURE 10

FIGURE 11

FIGURE 12

FIGURE 13

FIGURE 14

FIGURE 15

FIGURE 16

FIGURE 17

10

DI    B$_{in}$    ER

GO

R1

E11    E13, f$_{c13}$    R2    R3

f$_{c11}$    E12, f$_{c12}$    E21, f$_{c21}$    E31

Bout    Det

Sout

DM

DE    λ$_i$

11    fmod(1)    fmod(2)    fmod(3)

f$_{c11}$    f$_{c12}$    f$_{c13}$    f$_{c21}$    DDM

u$_{11}$    u$_{12}$    u$_{13}$    u$_{21}$    u$_{31}$

FIGURE 18

DM

DE

L1    λ$_{-1}$    MdA

L2    λ$_{-2}$    MdB

L3    λ$_{-3}$    MdA

L4    λ$_{-4}$    MdB

10

DI    ER    DMUX    λ$_{1,}$ λ$_{-2}$    PD1    DDM1

λ$_{3,}$ λ$_{-4}$    PD2    DDM2

FIGURE 19

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 3244169 A
- US 2016246000 A1

- EP 2866000 A

**Littérature non-brevet citée dans la description**

- **WESTERVELD et al.** Sensitive, small, broadband and scalable optomechanical ultrasound sensor in silicon photonics. *Nature Photonics Letters,* 2021

- **DIAO et al.** Integrated on-chip nano-optmechanical systems. *International Journal of High Speed Electronics and Systems,* 2017, vol. 26 (1,2
- **ALLAIN et al.** Optomechanical resonating probe for very high frequency sensing of atomic forces. *Nanoscale,* 2020, vol. 12, 2939